# EUROPEAN PATENT APPLICATION

(11) **EP 4 579 745 A1**
(43) Date of publication of application: **02.07.2025**
(21) Application number: 23873242.4
(22) Date of filing: 27.09.2023
(51) Int. Cl.: H01L 25/075, H01L 33/50, H01L 33/48, H01L 27/15

(54) **MICRO LED DISPLAY AND METHOD FOR MANUFACTURING SAME**

(30) Priority: 27.09.2022 KR 20220122408; 05.12.2022 KR 20220167567
(71) Applicant: Samsung Electronics Co., Ltd., Suwon-si, Gyeonggi-do 16677 (KR)
(72) Inventor: MUN, Ilju, Suwon-si, Gyeonggi-do 16677 (KR); JUNG, Jinwoo, Suwon-si, Gyeonggi-do 16677 (KR); KUK, Keon, Suwon-si, Gyeonggi-do 16677 (KR); KIM, Seongyong, Suwon-si, Gyeonggi-do 16677 (KR); ROH, Heebum, Suwon-si, Gyeonggi-do 16677 (KR); LEE, Daehee, Suwon-si, Gyeonggi-do 16677 (KR)
(74) Representative: Gulde & Partner
(86) International application number: PCT/KR2023/015092
(87) International publication number: WO 2024/072134

(57) **Abstract**

A display according to one embodiment of the present disclosure, which is a micro light-emitting diode (LED) display, may comprise: a barrier rib forming a pixel area; a micro LED disposed in a pixel area; a light-blocking portion defining an open area of the pixel area; a quantum dot color conversion layer formed in the pixel area; and a color filter layer disposed to correspond to the quantum dot color converter layer. The area of the pixel area may be larger than that of the open area. A first gap between adjacent pixel areas in a first direction may be narrower than a second gap between adj acent pixels in a second direction perpendicular to the first direction. Various other embodiments are possible.

## Description

### [Technical Field]

An embodiment of the present disclosure relates to a micro light emitting diode (micro LED) display and a method of manufacturing the same.

### [Background Art]

A display of an electronic device is a key technology in the information and communication era, and is developing in the direction of thinner, lighter, more portable, and higher performance. For example, a micro light emitting diode (micro LED) display, as a next-generation technology, possesses superior performance and durability compared to conventional display methods, and is being in active development. The micro LED (µLED) display may display images by arranging numerous pixels in a matrix form.

The micro LED (µLED) display uses micro LEDs (µLEDs) of 100µm or less, enabling red, green, and blue pixels to emit light by themselves. The micro LED (µLED) display, by displaying images through a self-emissive method, does not require a back light unit, unlike a liquid crystal display (LCD), resulting in superior efficiency. Additionally, by using inorganic materials, the micro LED (µLED) display ensures higher reliability compared to organic light emitting diodes (OLEDs) while enabling the implementation of high-brightness displays. In addition, the micro LED (µLED) display has a thinner thickness compared to LCDs and OLEDs, and has flexible characteristics, allowing it to be applied to flexible electronic devices.

The above-mentioned are provided solely as background information to aid in the understanding of the embodiments of the present disclosure. No determination has been made, and no assertion is made, as to whether any of the above-mentioned may be applicable as the prior art in relation to the present disclosure.

### [Disclosure of Invention]

### [Technical Problem]

In the manufacturing of micro LED (µLED) displays, it is necessary to precisely align a large number of micro LEDs (µLEDs) and transfer them from a wafer to a display substrate. With the need to transfer a large number of micro LEDs quickly and without error, there is a burden of reduced process yield and increased manufacturing costs. In addition, the different materials of blue micro LED devices, green micro LED devices, and red micro LED devices, as well as the complex pulse width modulation (PWM) control circuits that drive each color of LED devices, reduce the process yield of thin film transistor (TFT) substrates and increase manufacturing costs. To address the issues with manufacturing micro LED (µLED) displays, micro LED displays are being developed that can express red, green, and blue colors by applying a blue LED as a single light source and disposing a color converter layer (e.g., a QD color converter layer) that uses quantum dots (QDs) on top of the blue LED.

A photolithography method may be used to manufacture a color converter substrate for a micro LED display. A barrier rib structure that separates the pixels may be formed, and an exposure process using a mask may be performed to sequentially coat quantum dot (QD) ink in red, green, and blue colors on the color converter substrate. This enables the color converter layers of red, green, and blue to be formed on the color converter substrate. This method of manufacturing a color converter substrate may result in a larger amount of quantum dot (QD) ink being consumed during the photolithography process, leading to increased manufacturing costs.

An inkjet printing method may be used to manufacture the color converter substrate of a micro LED display. Inkjet printing is a method of ejecting small volumes of ink droplets through multiple arranged nozzles, with each droplet being controlled to eject based on a pattern in a drop-on-demand manner. This allows for substantially near 100 % material usage rate. By arranging a plurality of inkjet heads, large displays may be manufactured quickly. However, due to the high instability caused by the intermittent ink ejection method, it is difficult to achieve high display quality, and excessive maintenance is required to remove defective nozzles, which can lead to a low final material usage rate. In addition, to ensure high-quality patterns, multiple inkjet heads need to be frequently replaced, which may increase maintenance costs for major parts of the manufacturing equipment.

An embodiment of the present disclosure may provide a micro LED display that uses a blue LED as a single light source, and a method of manufacturing the same. A display (e.g., micro LED display) according to an embodiment of the present disclosure may enable pulse amplitude modulation (PAM) control by using a blue LED as a single light source, resulting in a simplified drive circuit. Further, since the degradation of all micro LEDs is uniform, image quality control may be advantageous. Color conversion using quantum dots (QDs) may provide a pure wavelength, resulting in a wider range of expressible color areas, and manufacturing efficiency may be improved by using blue LEDs with uniform wavelengths.

An embodiment of the present disclosure may provide a micro LED display and a method of manufacturing the same, which is capable of achieving high color conversion efficiency and high reliability by forming a quantum dot color converter pattern using an electro hydrodynamic (EHD) spinning process.

An embodiment of the present disclosure may provide a micro LED display including a barrier rib structure of a quantum dot (QD) color converter layer that is suitable for an EHD spinning process and is easy to manufacture, and a method of manufacturing the same.

An embodiment of the present disclosure may provide a micro LED display including a barrier rib structure of a color converter layer capable of guiding a stream of quantum dot (QD) ink to the center of a pixel during an EHD spinning process, and a method of manufacturing the same.

An embodiment of the present disclosure may provide a micro LED display having a metal layer formed on a barrier rib of a color converter layer to be suitable for an EHD spinning process, and a method of manufacturing the same.

Technical problems to be solved by the present disclosure are not limited to the above-mentioned technical problems, and other technical problems, which are not mentioned above, may be clearly understood from the following descriptions by those skilled in the art to which the present disclosure pertains.

A display according to one embodiment of the present disclosure, which is a micro light-emitting diode (LED) display, may comprise: a barrier rib forming a pixel area; a micro LED disposed in a pixel area; a light-blocking portion defining an open area of the pixel area; a quantum dot color converter layer formed in the pixel area; and a color filter layer disposed to correspond to the quantum dot color converter layer. The area of the pixel area may be larger than that of the open area. A first gap between adjacent pixel areas in a first direction may be narrower than a second gap between adjacent pixels in a second direction perpendicular to the first direction.

A method of manufacturing a display, according to an embodiment of the present disclosure, in a method of manufacturing a micro light emitting diode (LED) display, may include: forming a barrier rib defining a pixel area on a substrate; forming a light-blocking portion defining an open area of the pixel area; forming a quantum dot color converter layer in the pixel area; forming a color filter layer to correspond to the quantum dot color converter layer, in which an area of the pixel area may be formed larger than an area of the open area, and a first gap between the pixel areas adjacent in a first direction may be formed narrower than a second gap between pixels adjacent in a second direction perpendicular to the first direction.

The display and the method of manufacturing the same, according to an embodiment of the present disclosure, may form the barrier rib so that when the quantum dot color converter layer of the display is formed by EHD spinning, the quantum dot ink does not substantially remain on the top surface of the barrier rib. Therefore, the bonding between the light source substrate and the quantum dot color converter substrate can be smoothly achieved.

The display and the method of manufacturing the same, according to an embodiment of the present disclosure may prevent light leakage between a first pixel and a second pixel that are adjacent in the first direction (e.g., y-axis direction, vertical direction).

The display and the method of manufacturing the same, according to an embodiment of the present disclosure may form a barrier rib so that the quantum dot ink is ejected to the center of the pixel, thereby ensuring that the quantum dot ink does not substantially remain on the top surface of the barrier rib. Therefore, by ensuring smooth bonding between the light source substrate and the quantum dot color converter substrate, the quality of the product can be improved.

The micro LED display and the method of manufacturing the same, according to an embodiment of the present disclosure can reduce the manufacturing cost of the product.

The effects obtained by the present disclosure are not limited to the aforementioned effects, and other effects, which are not mentioned above, will be clearly understood by those skilled in the art from the following description.

### [Brief Description of Drawings]

In connection with the description of the drawings, the same or similar reference numerals may be used for the same or similar constituent elements.
FIG. 1 is a block diagram of an electronic device in a network environment according to an embodiment of the present disclosure.
FIG. 2A is a perspective view of a front surface of an electronic device according to an embodiment of the present disclosure.
FIG. 2B is a perspective view of a rear surface of an electronic device, according to an embodiment of the present disclosure.
FIG. 3A is a view illustrating a display panel according to an embodiment of the present disclosure.
FIG. 3B is a cross-sectional view of the display panel illustrated in FIG. 3A.
FIG. 3C is a view illustrating an arrangement of pixels disposed on a display panel.
FIG. 4 is a block diagram of a display module according to an embodiment of the present disclosure.
FIG. 5 is a view illustrating a micro LED display, according to an embodiment of the present disclosure.
FIGS. 6 to 8 are views illustrating a method of manufacturing the micro LED display illustrated in FIG. 5.
FIG. 9 is a view illustrating the shape of a barrier rib formed in a quantum dot color converter substrate according to an embodiment of the present disclosure.
FIG. 10 is a view illustrating a shape of a barrier rib formed in a quantum dot color converter substrate according to an embodiment of the present disclosure.
FIG. 11 is a view illustrating a shape of a barrier rib formed in a quantum dot color converter substrate according to an embodiment of the present disclosure.
FIG. 12 is a view illustrating the shape of a barrier rib formed in a quantum dot color converter substrate according to an embodiment of the present disclosure.
FIG. 13A is a view illustrating the shape of a barrier rib formed in a quantum dot color converter substrate according to an embodiment of the present disclosure.
FIG. 13B is a view illustrating the shape of a barrier rib formed in a quantum dot color converter substrate according to an embodiment of the present disclosure.
FIG. 13C is a view illustrating the shape of a barrier rib formed in a quantum dot color converter substrate according to an embodiment of the present disclosure.
FIG. 13D is a view illustrating the shape of a barrier rib formed in a quantum dot color converter substrate according to an embodiment of the present disclosure.
FIG. 13E is a view illustrating the shape of a barrier rib formed in a quantum dot color converter substrate according to an embodiment of the present disclosure.
FIG. 13F is a view illustrating the shape of a barrier rib formed in a quantum dot color converter substrate according to an embodiment of the present disclosure.
FIG. 14 is a top plan view illustrating a barrier rib formed on a quantum dot color converter substrate and a conductive layer formed on top of the barrier rib, according to an embodiment of the present disclosure.
FIG. 15 is a cross-sectional view taken along line A1-A2 and line B1-B2 illustrated in FIG. 14.
FIG. 16 is a top plan view illustrating a barrier rib formed on a quantum dot color converter substrate and a conductive layer formed on top of the barrier rib, according to an embodiment of the present disclosure.
FIG. 17 is a cross-sectional view taken along line A1-A2 and line B1-B2 illustrated in FIG. 16.
FIG. 18 is a top plan view illustrating a barrier rib formed on a quantum dot color conversion substrate and a conductive layer formed on top of the barrier rib, according to an embodiment of the present disclosure.
FIG. 19 is a top plan view illustrating a barrier rib formed on a quantum dot color converter substrate and a conductive layer formed on top of the barrier rib, according to an embodiment of the present disclosure.
FIG. 20 is a cross-sectional view taken along line A1-A2 and line B1-B2 illustrated in FIG. 19.
FIGS. 21 and 22 are views illustrating a method of forming a quantum dot color converter layer.

Throughout the drawings, it should be noted that the same reference numbers are used to describe the same or similar elements, features, and structures.

### [Mode for the Invention]

The following description with reference to the accompanying drawings is provided to give a comprehensive understanding of the various embodiments of the present disclosure, as defined by the claims and the equivalents thereof. Various specific details are included herewith for the purpose of the understanding, but should be considered as illustrative only. Therefore, those skilled in the art will recognize that various alterations and modifications may be made to the various embodiments disclosed in the present specification without departing from the scope and spirit of the content of the present disclosure. In addition, for clarity and conciseness, descriptions of well-known features and constitutions may be omitted.

The terms and words used in the following descriptions and claims are not limited to their literary meanings, but are merely those used by the applicant to enable a clear and consistent understanding of the present document. Therefore, it should be obvious to those skilled in the art that the following descriptions of various embodiments of the present document, as defined by the appended claims and the equivalents thereof, are not intended to limit the present document, but are provided solely for the purpose of illustration.

The singular form should be understood to include the plural referents unless the context clearly dictates otherwise. Therefore, for example, a reference to a "surface of a constituent element" may include a reference to one or more of those surfaces.

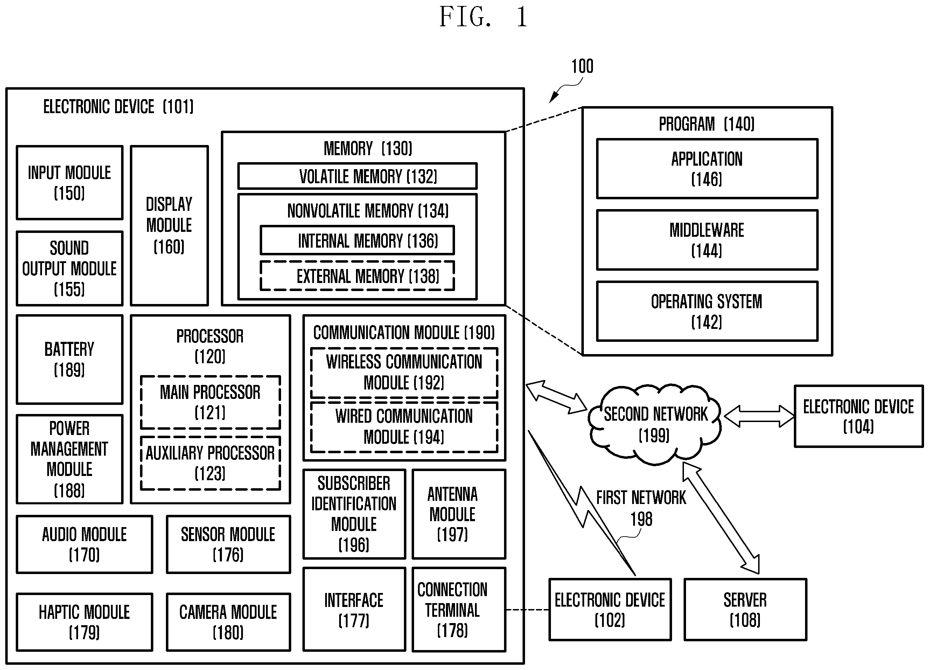

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment, the display module 160 illustrated in FIG. 1 is described as including a foldable display or a flexible display, but the present disclosure is not limited thereto. The display module 160 may include a bar-type or plate-type display (e.g., micro LED display).

According to an embodiment, the display module 160 illustrated in FIG. 1 may include a flexible display (e.g., flexible micro LED display) configured to allow a screen (e.g., display screen) to be folded or unfolded.

According to an embodiment, the display module 160 illustrated in FIG. 1 may include a flexible display (e.g., flexible micro LED display) that is slidably disposed to provide a screen (e.g., display screen).

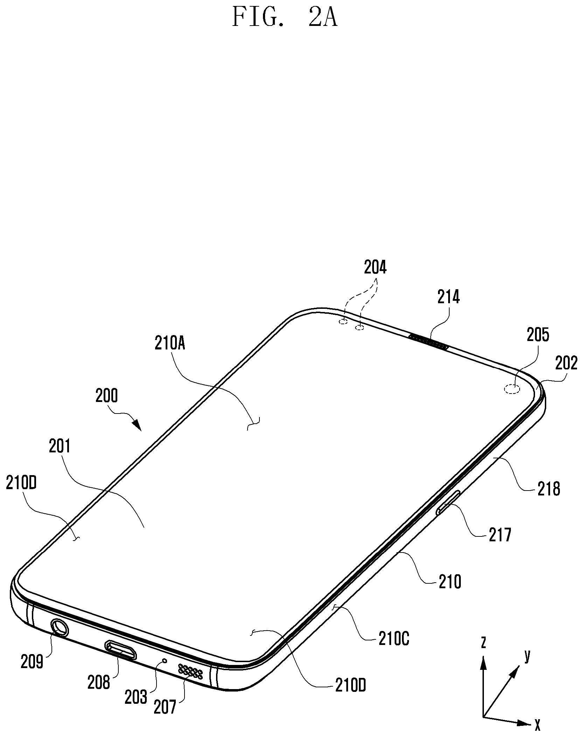

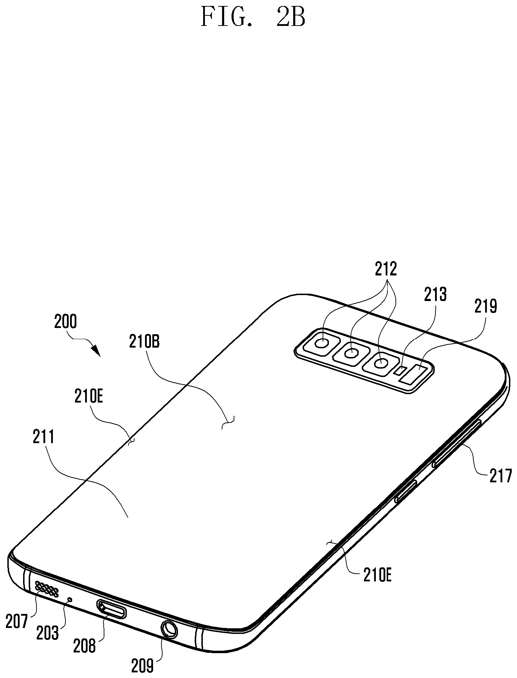

FIG. 2A is a perspective view of a front surface of an electronic device according to an embodiment of the present disclosure. FIG. 2B is a perspective view of a rear surface of an electronic device, according to an embodiment of the present disclosure.

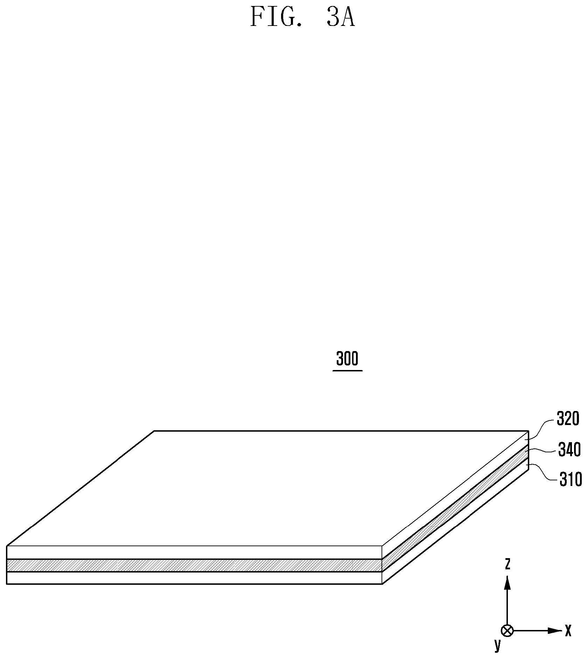

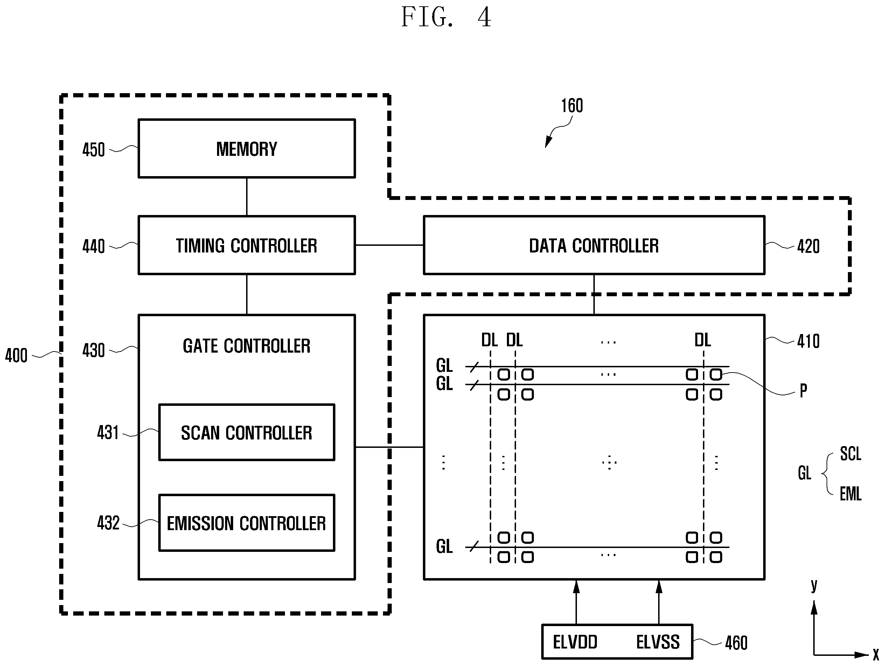

With reference to FIGS. 2A and 2B, an electronic device 200 (e.g., electronic device 101 in FIG. 1) according to an embodiment of the present disclosure may include a first surface (or front surface) 210A, a second surface (or rear surface) 210B, and a housing 210. The electronic device 200 (e.g., electronic device 101 in FIG. 1) may include a display 201 (e.g., display 320 in FIG. 3A, display 410 in FIG. 4) according to an embodiment of the present disclosure.

According to an embodiment, the display 201 may be supported by the housing 210. For example, the display 210 may include a micro LED display.

According to an embodiment, the housing 210 may include a side surface 210C that surrounds a space between the first surface 210A and the second surface 210B. According to an embodiment, the housing 210 may refer to a structure forming some of the first surface 210A, the second surface 210B, and the side surfaces 210C.

According to an embodiment, the first surface 210A may be formed by a front surface plate 202 (e.g., glass plate including various coating layers, or polymer plate) that is at least partially and substantially transparent.

According to an embodiment, the second surface 210B may be formed by a substantially opaque rear surface plate 211. The rear surface plate 211 may be formed, for example, of coated or tinted glass, ceramic, polymer, metal (e.g., aluminum, stainless steel (STS), or magnesium), or a combination of at least two of the above materials. However, the present disclosure is not limited thereto, and the rear surface plate 211 may also be formed by transparent glass.

According to an embodiment, the side surface 210C, which is coupled with the front surface plate 202 and the rear surface plate 211, may be formed by a side surface bezel structure (or "lateral member") 218 that includes a metal and/or polymer. According to an embodiment, the rear surface plate 211 and the side surface bezel structure 218 may be integrally formed and include the same material (e.g., metallic material such as aluminum).

According to an embodiment, the front surface plate 202 may include two first areas 210D that curve from the first surface 210A toward the rear surface plate 211 and extend seamlessly. The two first areas 210D may be disposed at both ends of the long edges of the front surface plate 202.

According to an embodiment, the rear surface plate 211 may include two second areas 210E, which curve from the second surface 210B toward the front surface plate 202 and extend seamlessly.

According to an embodiment, the front surface plate 202 (or rear surface plate 211) may include only one of the first areas 210D (or second areas 210E). According to an embodiment, some of the first areas 210D or the second areas 210E may not be included. In embodiments, when viewed from the side surface of the electronic device 200, the side surface bezel structure 218 may have a first thickness (or width) on a side surface where the first areas 210D or the second areas 210E are not included, and may have a second thickness, thinner than the first thickness, on a side surface where the first areas 210D or the second areas 210E are included.

According to an embodiment, the electronic device 200 may include at least one of a display 201, a sound input device 203 (e.g., input module 150 in FIG. 1), sound output devices 207 and 214 (e.g., sound output module 155 in FIG. 1), sensor modules 204 and 219 (e.g., sensor module 176 in FIG. 1), camera modules 205 and 212 (e.g., camera module 180 in FIG. 1), a flash 213, a key input device 217, an indicator (not illustrated), or connectors 208 and 209. According to an embodiment, the electronic device 200 may omit at least one of the constituent elements (e.g., key input device 217) or further include other constituent elements.

According to an embodiment, the display 201 may be visually visible through an upper end portion of the front surface plate 202.

According to an embodiment, at least a portion of the display 201 may be visible through the front surface plate 202, which forms the first surface 210A and the first areas 210D of the side surface 210C. The display 201 may be coupled or disposed adjacent to a touch detection circuit, a pressure sensor capable of measuring intensity (pressure) of a touch, and/or a digitizer capable of detecting a magnetic stylus pen.

According to an embodiment, at least a portion of the sensor modules 204 and 219, and/or at least a portion of the key input device 217, may be disposed in the first area 210D and/or the second area 210E.

According to an embodiment, the rear surface of the screen display area of the display 201 may include at least one of the sensor module 204, camera modules 205 (e.g., an image sensor), audio module 214, or a fingerprint sensor.

According to an embodiment, the display 201 may be combined with or disposed adjacent to a touch detection circuit, a pressure sensor capable of measuring the intensity (pressure) of a touch, and/or a digitizer for detecting a stylus pen in a manner of a magnetic field.

According to an embodiment, at least a portion of the sensor modules 204 and 219, and/or at least a portion of the key input device 217, may be disposed in the first areas 210D and/or the second areas 210E.

According to an embodiment, the sound input device 203 may include a microphone. According to an embodiment, the input device 203 may include a plurality of microphones disposed to be able to detect the direction of sound.

According to an embodiment, the audio output devices 207 and 214 may include an external speaker 207 and a call receiver (e.g., audio module 214). In some embodiments, the sound input device 203 (e.g., microphone), audio output devices 207 and 214, and connectors 208 and 209 may be disposed within the internal space of the electronic device 200 and may be exposed to the external environment through at least one hole formed in the housing 210. In some embodiments, the hole formed in the housing 210 may be used in common for both the sound input device 203 (e.g., microphone) and the audio output devices 207 and 214. In some embodiments, the audio output devices 207 and 214 may include a speaker (e.g., piezo speaker) that operates with the hole formed in the housing 210 excluded.

According to an embodiment, the sensor modules 204 and 219 (e.g., sensor module 176 in FIG. 1) may generate electrical signals or data values corresponding to the operating state inside the electronic device 200 or an external environmental state. The sensor modules 204 and 219 may include, for example, a first sensor module 204 (e.g., proximity sensor) disposed on the first surface 210A of the housing 210, and/or a second sensor module 219 (e.g., HRM sensor) disposed on the second surface 210B of the housing 210, and/or a third sensor module (not illustrated) (e.g., fingerprint sensor). For example, the fingerprint sensor may be disposed on the first surface 210A (e.g., display 201) and/or the second surface 210B of the housing 210. The electronic device 200 may further include at least one of a sensor module not illustrated, such as a gesture sensor, a gyro sensor, a barometric pressure sensor, a magnetic sensor, an accelerometer, a grip sensor, a color sensor, an infrared sensor, a biometric sensor, a temperature sensor, a humidity sensor, or an illuminance sensor.

According to an embodiment, the camera modules 205 and 212 may include a first camera module 205 disposed on the first surface 210A of the electronic device 200, and a second camera module 212 disposed on the second surface 210B. The flash 213 may be disposed around the camera modules 205 and 212. The camera modules 205 and 212 may include one or a plurality of lenses, an image sensor, and/or an image signal processor. For example, the flash 213 may include a light-emitting diode or a xenon lamp.

According to an embodiment, the first camera module 205 may be disposed beneath the display panel of the display 201 using an under display camera (UDC) method. According to an embodiment, two or more lenses (e.g., wide-angle and telephoto lenses) and image sensors may be disposed on a single surface of the electronic device 200. According to an embodiment, a plurality of first camera modules 205 may be disposed on the first surface of the electronic device 200 (e.g., a surface where the screen is displayed) using an under display camera (UDC) method.

According to an embodiment, the key input device 217 may be disposed on the side surface 210C of the housing 210. According to an embodiment, the electronic device 200 may not include some or all of the aforementioned key input devices 217, and the excluded key input devices 217 may be implemented in other forms, such as soft keys, on the display 201. According to an embodiment, the key input device 217 may be implemented using a pressure sensor included in the display 201.

According to an embodiment, the connectors 208 and 209 may include a first connector hole 208, which may accommodate a connector (e.g., USB connector) for transmitting and receiving power and/or data with an external electronic device, and/or a second connector hole 209 (or earphone jack), which may accommodate a connector for transmitting and receiving audio signals with an external electronic device. The first connector hole 208 may include a universal serial bus (USB) Type-A port or a USB Type-C port. When the first connector hole 208 supports USB Type-C, the electronic device 200 (e.g., electronic device 101 in FIG. 1) may support USB power delivery (PD) charging.

According to an embodiment, the first camera module 205, which is some of the camera modules 205 and 212 and/or the sensor module 204, which is some of the sensor modules 204 and 219 may be disposed to be visually visible through the display 201.

According to an embodiment, when the first camera module 205 is disposed with an under display camera (UDC) method, the first camera module 205 may not be visually visible from the outside.

According to an embodiment, the first camera module 205 may be disposed to overlap the display area, and the screen may also be displayed in an display area corresponding to the first camera module 205. Some sensor modules 204 may be disposed within the internal space of the electronic device 200 to perform their functions without being visually exposed through the front surface plate 202.

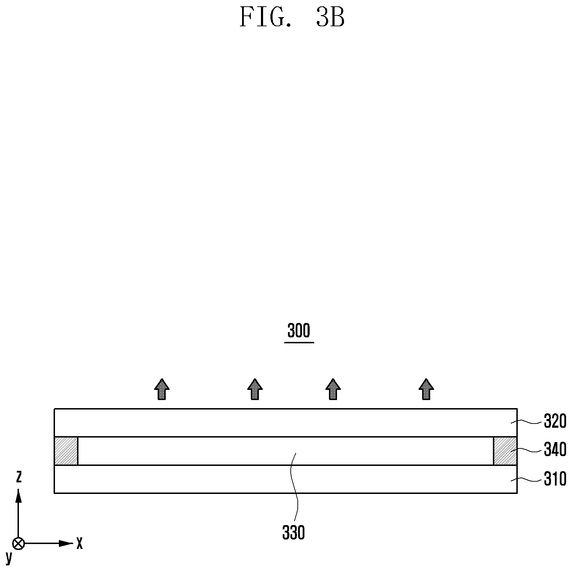

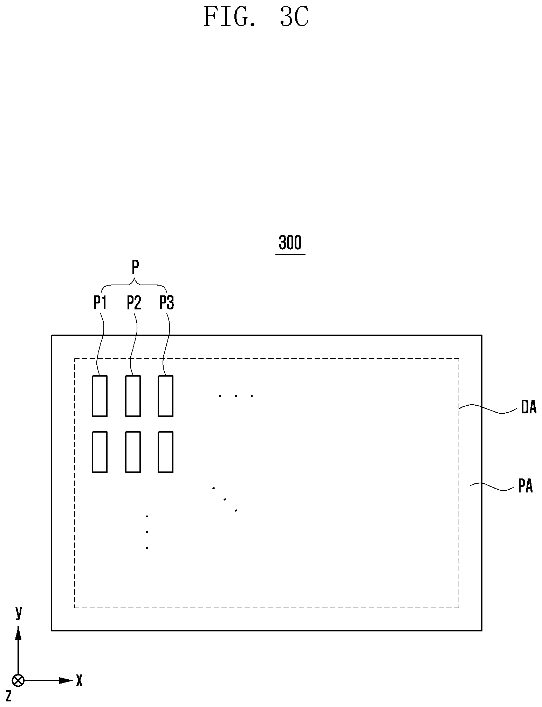

FIG. 3A is a view illustrating a display panel according to an embodiment of the present disclosure. FIG. 3B is a cross-sectional view of the display panel illustrated in FIG. 3A. FIG. 3C is a view illustrating an arrangement of pixels disposed on a display panel. A display panel 300 illustrated in FIGS. 3A to 3C may be applied to large-screen devices such as televisions (TVs), monitors, or video wall displays for displaying images.

With reference to FIGS. 3A to 3C, the display panel 300 according to an embodiment of the present disclosure may include a light-emitting panel 310, a color converter panel 320, a light-transmitting layer 330 positioned between the light-emitting panel 310 and the color converter panel 320, and a coupling member 340 that combines the light-emitting panel 310 and the color converter panel 320.

According to an embodiment, the light-emitting panel 310 and the color converter panel 320 may be disposed to face each other with the light-transmitting layer 330 interposed therebetween. The color converter panel 320 may be disposed in the direction in which light is emitted from the light-emitting panel 310. The coupling member 340 is disposed along the edges of the light-emitting panel 310 and the color converter panel 320. For example, the coupling member 340 may include a sealing member.

According to an embodiment, the display panel 300 may include a display area DA for displaying images and a non-display area PA. For example, the non-display area PA is positioned around the display area DA, and the coupling member 340 may be disposed in the non-display area.

According to an embodiment, the display area DA may include a plurality of pixels P arranged along a first direction (e.g., x-axis direction) and a second direction (e.g., y-axis direction). Each pixel P may include a plurality of sub-pixels P1, P2, and P3 that display different colors. For example, three sub-pixels P1, P2, and P3 may come together to form one pixel P. However, the present disclosure is not limited thereto, and one pixel P may also be composed of four or more sub-pixels.

For example, the plurality of pixels P may be arranged in configurations such as a bayer matrix, a pentile matrix, and/or a diamond matrix, but are not limited thereto.

For example, each sub-pixel P1, P2, or P3 may display three primary colors or a combination of the three primary colors. Each sub-pixel P1, P2, or P3 may display red, green, blue, or a combination of these colors. For example, the first subpixel P1 may display a red color, the second subpixel P2 may display a green color, and the third subpixel P3 may display a blue color. For example, the sub-pixels P1, P2, and P3 may have the same area, but are not limited thereto, and each of the sub-pixels P1, P2, and P3 may have different areas.

The display panel 300 according to an embodiment of the present disclosure may be applied to bar-type, foldable-type, rollable-type, sliding-type, wearable-type devices, tablet PCs, and/or notebook PCs. The display panel 300 according to an embodiment of the present disclosure may include large-screen display panels (e.g., televisions (TVs), monitors, and video wall displays).

The electronic device according to an embodiment of the present disclosure is not limited to the aforementioned examples and may include various other electronic devices.

FIG. 4 is a block diagram of a display module according to an embodiment of the present disclosure.

The display module 160 illustrated in FIG. 4 may be at least partially similar or identical to the display module 160 illustrated in FIG. 1. The display module 160 illustrated in FIG. 4 may include a different embodiment from the display module 160 illustrated in FIG. 1.

With reference to FIG. 4, the display module 160 may include a display 410 (e.g., display 201 in FIG. 2A or display 320 in FIG. 3A), a display driver integrated circuit (IC) 400 (hereinafter, referred to as "DDI" 400) for driving the display 410, and a power supply device 460 for supplying power (ELVDD, ELVSS) to the display 410.

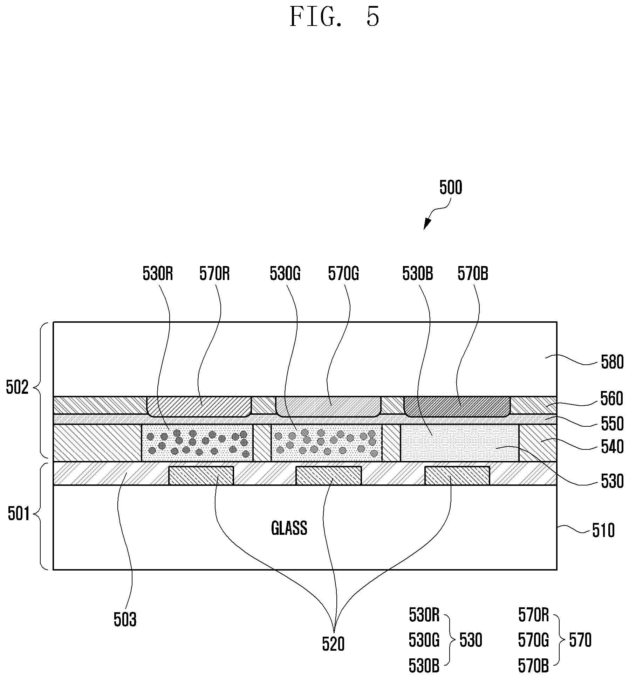

According to an embodiment, the display 410 may include a micro LED display in which a plurality of micro LEDs (e.g., micro LEDs 520 in FIG. 5) are disposed. The display 410 may include a light source substrate (e.g., light source substrate 501 in FIG. 5) (e.g., a micro LED substrate) and a quantum dot color converter substrate for color conversion (e.g., quantum dot color converter substrate 502 in FIG. 5). The display 410 may include a plurality of pixels P disposed in a matrix form, with each pixel P having a micro LED 520 and a color converter layer (e.g., color converter layer 530 in FIG. 5) disposed therein. For example, one unit pixel may be composed of a red pixel, a green pixel, and a blue pixel.

According to an embodiment, the DDI 400 may include a data controller 420, a gate controller 430, a timing controller 440, and a memory 450.

For example, at least some of the data controller 420, gate controller 430, timing controller 440, and memory 450 may be disposed on a substrate where the display 410 is formed, while the remaining parts may be included in the DDI 400.

For example, at least some of the data controller 420, gate controller 430, timing controller 440, and memory 450 may be included in the display 410. when at least some of the data controller 420, gate controller 430, timing controller 440, and memory 450 are included in the display 410, they may be disposed in the non-display area (e.g., bezel area) of the display 410.

According to an embodiment, the display 410 may include a plurality of gate lines GL and a plurality of data lines DL. For example, the plurality of gate lines GL may be formed in the first direction (e.g., x-axis direction, horizontal direction in FIG. 4) and disposed at designated intervals. For example, the plurality of data lines DL may be formed in the second direction (e.g., y-axis direction, vertical direction in FIG. 4) substantially perpendicular to the first direction and disposed at designated intervals.

In the embodiments of the present disclosure, the "scan direction of the display 410" may be defined as a direction perpendicular to a direction in which the gate lines GL are formed (e.g., vertical direction, y-axis direction), which corresponds to the horizontal direction (e.g., x-axis direction). For example, when the plurality of gate lines GL are formed in the first direction (e.g., horizontal direction, x-axis direction in FIG. 4), the scan direction of the display 410 may be defined as the second direction (e.g., vertical direction, y-axis direction in FIG. 4), which is perpendicular to the first direction.

According to an embodiment, a pixel P may be disposed in each of partial areas of the display 410 where the multiple gate lines GL and the multiple data lines DL intersect each other.

According to an embodiment, each pixel P may be electrically connected to the gate line GL and the data line DL to display a designated gradation.

According to an embodiment, the power supply device 460 may generate a driving voltage (ELVDD, ELVSS) to illuminate the micro LEDs (e.g., micro LEDs 520 in FIG. 5) disposed in the plurality of pixels P. The power supply device 460 may provide the driving voltage (ELVDD, ELVSS) to the micro LEDs (e.g., micro LEDs 520 in FIG. 5) disposed in the display 410.

According to an embodiment, the pixels P may receive scan signals and emission (EM) signals through the gate lines GL and receive data signals through the data lines DL. According to an embodiment, the pixels P may receive a high-potential voltage (e.g., ELVDD voltage) and a low-potential voltage (e.g., ELVSS voltage) as power sources for driving the micro LEDs 520.

According to an embodiment, each pixel P may include a pixel driving circuit (e.g., a plurality of transistors and a plurality of capacitors) for driving the micro LED 520.

According to an embodiment, the pixel driving circuit disposed in each pixel P may control the on state (e.g., active state) or off state (e.g., inactive state) of the micro LED 520 based on the scan signals and emission signals.

According to an embodiment, when the micro LED 520 of each pixel P is in the on state (e.g., active state), the micro LED 520 may display a gradation (e.g., brightness) corresponding to the data signal for one frame period (or for part of one frame period).

According to an embodiment, the data controller 420 may drive multiple data lines DL. According to an embodiment, the data controller 420 may receive at least one synchronization signal, and a data signal (e.g., digital image data) from the timing controller 440 or the processor (e.g., processor 120 in FIG. 1). According to an embodiment, the data controller 420 may determine a data voltage (data) corresponding to an input data signal (e.g., analogue image data) using a reference gamma voltage and a designated gamma curve. According to an embodiment, the data controller 420 may supply the data voltage (data) to each pixel P by applying the data voltage (data) to multiple data lines DL.

According to an embodiment, the processor (e.g., processor 120 in FIG. 1) may control the overall operation of the display module 160. The processor 120 may be composed of one or multiple processors. For example, the processor 120 may execute at least one instruction stored in the memory (e.g., memory 130 in FIG. 1) to allow the operation of the display module 160 according to various embodiments of the present disclosure to be performed.

According to an embodiment, the processor 120 may be implemented as a digital signal processor (DSP) for processing digital video signals, a microprocessor, a graphics processing unit (GPU), an artificial intelligence (AI) processor, a neural processing unit (NPU), or a time controller (TCON). However, the present disclosure is not limited thereto and the processor 120 may include or be defined by one or more of a central processing unit (CPU), a microcontroller unit (MCU), a microprocessing unit (MPU), a controller, an application processor (AP), a communication processor (CP), or an ARM processor. In addition, the processor 120 may be implemented as a system on chip (SoC) or large-scale integration (LSI) with embedded processing algorithms, or as the form of an application-specific integrated circuit (ASIC) or field-programmable gate array (FPGA).

According to an embodiment, the processor 120 may run an operating system or application to control the hardware or software components connected to the processor 120 and perform various data processing and computations. Additionally, the processor 120 may load commands or data received from at least one of the other constituent elements into volatile memory for processing and store various data in the memory 130.

According to an embodiment, the data controller 420 may receive a plurality of synchronization signals with the same frequency (or different frequencies) on a frame-by-frame basis from the timing controller 440 or the processor (e.g., processor 120 in FIG. 1). For example, consecutive first and second frames may be driven based on a plurality of synchronization signals with the same frequency (or different frequencies).

According to an embodiment, the data control unit 420 may receive a plurality of synchronization signals with the same frequency (or different frequencies) on a frame-by-frame basis from the timing control unit 440 or the processor (e.g., processor 120 in FIG. 1). For example, consecutive first and second frames may be driven based on a plurality of synchronization signals with the same frequency (or different frequencies).

According to an embodiment, the gate controller 430 may drive the plurality of gate lines GL. According to an embodiment, the gate controller 430 may receive at least one synchronization signal from the timing controller 440 or the processor (e.g., processor 120 in FIG. 1).

According to an embodiment, each gate line GL may include scan signal lines (SCL) for applying scan signals and emission signal lines (EML) for applying emission signals.

According to an embodiment, the gate controller 430 may include a scan controller 431 that sequentially generates a plurality of scan signals based on the synchronization signal and supplies the generated plurality of scan signals to the scan signal lines (SCL).

According to an embodiment, the gate controller 430 may further include an emission controller 432 that sequentially generates a plurality of emission (EM) signals based on the synchronization signal and supplies the generated plurality of emission (EM) signals to the emission signal lines (EML).

According to an embodiment, the gate controller 430 may receive a masking signal from the timing controller 440 or the processor (e.g., processor 120 in FIG. 1).

According to an embodiment, the gate controller 430 may not, based on the masking signal, supply at least one of the scan signal and/or emission signal to at least some of the gate lines GL in the display 410. For example, the gate controller 430 may, based on the masking signal, supply the scan signal and/or emission signal to only at least some of the plurality of gate lines GL and may not supply the scan signal and/or emission signal to the remaining gate lines GL.

According to an embodiment, among the plurality of pixels disposed in the display 410, the pixels connected to the gate lines GL that do not be supplied with the scan signal and/or emission signal may remain off (e.g., inactive) during the corresponding frame period. In an embodiment, the operation of the gate controller 430 receiving the masking signal from the timing controller 440 or the processor 120 may be omitted.

According to an embodiment, the timing controller 440 may control drive timing of the data controller 420 and the gate controller 430. According to an embodiment, the timing controller 440 may receive data signals from the processor 120 on a frame-by-frame basis. According to an embodiment, the timing controller 440 may convert the data signal (e.g., digital image data) input from the processor 120 to correspond to a resolution of the display 410, and supply the converted data signal to the data controller 420.

According to an embodiment, the display module 160 may further include a touch circuit (e.g., a touch sensor). For example, at least a portion of the touch circuit may be included as part of the DDI 400 or the display 410.

According to an embodiment, the display module 160 may further include at least one sensor of the sensor module 176 (e.g., fingerprint sensor, iris sensor, pressure sensor, or illuminance sensor), or a control circuit therefor. In this case, the at least one sensor or control circuit therefor may be embedded as part of the display module 160 (e.g., display 410 or DDI 400). For example, in case that the sensor module 176 embedded in the display module 160 includes a biometric sensor (e.g., fingerprint sensor), the biometric sensor may obtain biometric information (e.g., fingerprint image) related to a touch input through some area of the display 410. For another example, when the sensor module 176 embedded in the display module 160 includes a pressure sensor, the pressure sensor may obtain pressure information related to a touch input through some or all areas of the display 410. According to an embodiment, the touch sensor or the sensor module 176 may be disposed between pixels in a pixel layer of the display 410, or on or underneath the pixel layer.

According to an embodiment, the display 410 (e.g., a micro LED display) illustrated in FIG. 4 may be applied to wearable devices, portable devices, handheld devices, and various mobile devices that require displays.

According to an embodiment, the display 410 (e.g., a micro LED display) illustrated in FIG. 4 may be applied to electronic devices such as wireless communication devices.

According to an embodiment, the display 410 (e.g., a micro LED display) illustrated in FIG. 4 may be applied to televisions (TVs).

According to an embodiment, the display 410 (e.g., a micro LED display) illustrated in FIG. 4 may be applied to devices with display functions, such as video walls, large format displays (LFD), digital signage, digital information displays (DID), and projector displays.

According to an embodiment, the display 410 (e.g., a micro LED display) illustrated in FIG. 4 may be applied to various display devices, such as monitors for personal computers (PCs) where multiple displays are implemented and assembled in a matrix type, high-resolution televisions (TVs), signage (or digital signage), and electronic displays.

FIG. 5 is a view illustrating a micro LED display, according to an embodiment of the present disclosure.

With reference to FIG. 5, a display 500 (e.g., a micro LED display) according to an embodiment of the present disclosure (e.g., display 201 in FIG. 2A, display 320 in FIG. 3A, display 410 in FIG. 4) may include a light source substrate 501 (e.g., a micro LED substrate) and a quantum dot color converter substrate 502.

According to an embodiment, the light source substrate 501 (e.g., a micro LED substrate) may include a glass substrate 510, a plurality of micro LEDs 520 disposed on the glass substrate 510, and pixel circuits for driving the plurality of micro LEDs 520. For example, in the light source substrate 501 (e.g., a micro LED substrate), a plurality of pixels (e.g., pixels P in FIG. 4) may be defined, and a micro LED 520 may be disposed in each of the plurality of pixels P.

According to an embodiment, the quantum dot color converter substrate 502 may include a quantum dot (QD) color converter layer 530, barrier ribs 540, a planarization layer 550, a light-blocking layer 560 (e.g., a black matrix (BM)), a color filter layer 570, and a transparent substrate 580 (e.g., transparent glass).

For example, the barrier ribs 540 may separate the areas of each pixel, and the quantum dot (QD) color converter layer 530 may be disposed in each pixel area. The color filter layer 570 may be disposed on the quantum dot (QD) color converter layer 530 of each pixel. The light-blocking layer 560 may be disposed between the color filter layers 570 of each pixel to prevent color mixing between pixels and to separate the area of each pixel. The transparent substrate 580 (e.g., transparent glass) may be disposed on top of the color filter layer 570.

According to an embodiment, during the manufacturing of the display 500, the light source substrate 501 (e.g., a micro LED substrate) and the quantum dot color converter substrate 502 may be individually manufactured and then bonded together using an adhesive layer 503.

According to one embodiment, the micro LEDs 520 may be applied as a single light source, with blue LEDs generating blue-colored light.

According to an embodiment, the color of each pixel may be defined by the color of the quantum dot (QD) color converter layer 530 disposed on top of the micro LEDs 520 and the color of the color filter layer 570.

For example, a single unit pixel may be composed of a red pixel, a green pixel, and a blue pixel.

For example, a red color converter layer 530R and a red color filter layer 570R may be disposed on top of the blue-colored micro LED 520, forming a red pixel that displays red-colored light. The red pixel may allow the blue light generated by the blue-colored micro LED 520 to be converted into red light through the red color converter layer 530R and the red color filter layer 570R, enabling the red light to be output.

For example, a green color converter layer 530G and a green color filter layer 570G may be disposed on top of the blue-colored micro LED 520, forming a green pixel that displays green-colored light. The green pixel may allow the blue light generated by the blue-colored micro LED 520 to be converted into green light through the green color converter layer 530G and the green color filter layer 570G, enabling the green light to be output.

For example, a transparent layer 530G (or a blue color converter layer) and a blue color filter layer 570B may be disposed on top of the blue-colored micro LED 520, forming a blue pixel that displays blue-colored light. The blue pixel may allow the blue light generated by the blue-colored micro LED 520 to pass through the transparent layer 530G without alteration and filter out other colors of light in the blue color filter layer 570B, enabling only the blue light to be output.

In the description with reference to FIG. 4, it was stated that the pixel is applied with the blue-colored micro LED 520, but the present disclosure is not limited thereto and the pixel may also be applied with a white-colored micro LED.

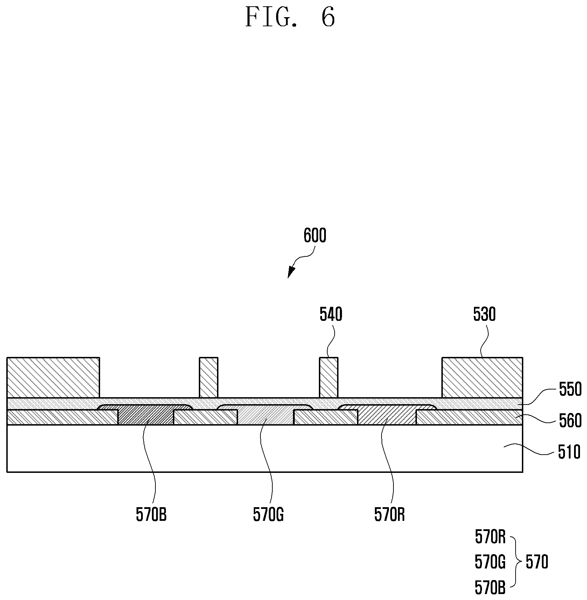

FIGS. 6 to 8 are views illustrating a method of manufacturing the micro LED display illustrated in FIG. 5. FIGS. 6 to 8 illustrate an example of a method of manufacturing the quantum dot color converter substrate 502 of the micro LED display 500.

With reference to FIGS. 5 and 6, according to an embodiment, for the manufacturing of the quantum dot color converter substrate 502 of the micro LED display 500, the light-blocking layer 560 may be formed, on the transparent substrate 580, on portions except for the open areas (e.g., aperture areas) of each pixel. The color filter layer 570 may be formed in the open areas of each pixel formed by the light-blocking layer 560. For example, the red color filter layer 570R may be formed in the red pixel area, the green color filter layer 570G may be formed in the green pixel area, and the blue color filter layer 570B may be formed in the blue pixel area.

According to an embodiment, the planarization layer 550 may be formed to cover the color filter layer 570. According to an embodiment, the barrier ribs 540 may be formed on the planarization layer 550.

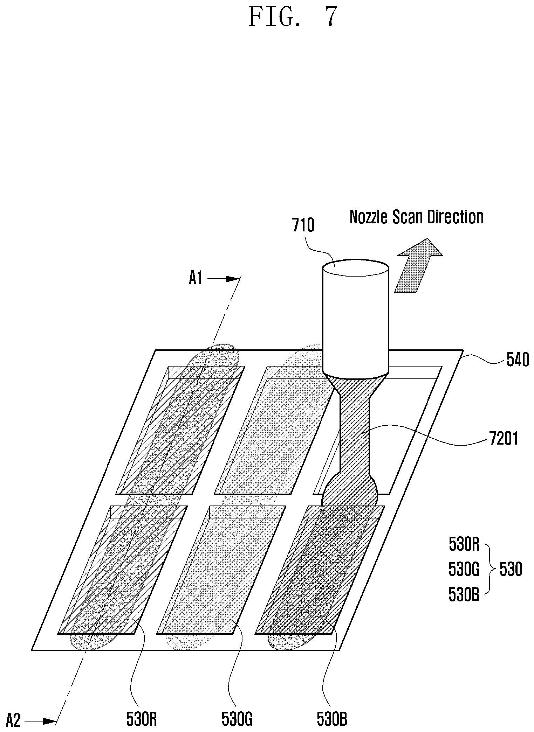

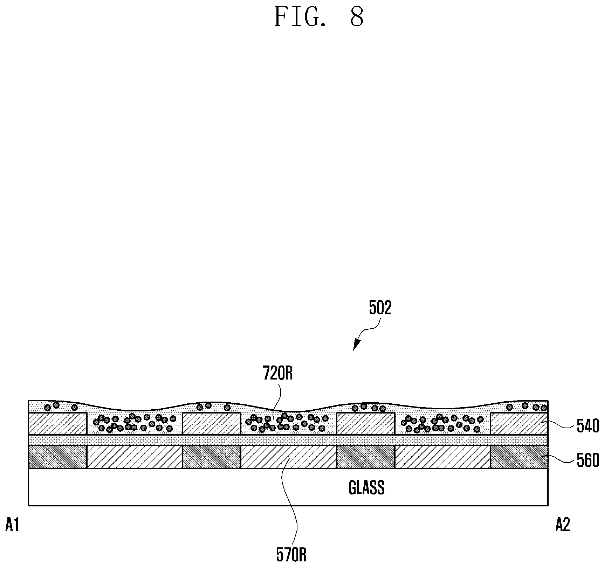

FIG. 8 illustrates a cross-section along line A1-A2 in FIG. 7.

With reference to FIGS. 5, 7, and 8, according to an embodiment, pixels of the same color aligned in the advancing direction of a nozzle 710 are separated by barrier ribs 540. For example, the quantum dot (QD) color converter layer 530 may be formed in each pixel area separated by the barrier ribs 540 using an electro hydrodynamic (EHD) spinning process.

For example, quantum dot (QD) ink 7201 may be applied to each pixel area using the nozzle 710. For example, the quantum dot (QD) ink 7201 may include a photosensitive resin and a plurality of quantum dots.

For example, the quantum dot (QD) ink 7201 may be sequentially applied to the red pixel area, the green pixel area, and the blue pixel area.

For example, the red-colored quantum dot (QD) ink 7201 may be applied to the red pixel area to form the red color converter layer 530R. When applying the quantum dot (QD) ink 7201 to the red pixel area, the red-colored quantum dot (QD) ink 7201 may be applied along a centerline R of the red pixel. After aligning the nozzle 710 with the centerline R of the red pixels, the nozzle may be moved in the scan direction to apply the red-colored quantum dot (QD) ink 7201 for color conversion to a plurality of red pixels.

For example, the green-colored quantum dot (QD) ink 7201 may be applied to the green pixels to form the green color converter layer 530G. When applying the quantum dot (QD) ink 7201 to the green pixel area, the green-colored quantum dot (QD) ink 7201 may be applied along a centerline G of the green pixel. After aligning the nozzle 710 with the centerline G of the green pixels, the nozzle may be moved in the scan direction to apply the green-colored quantum dot (QD) ink 7201 for color conversion to a plurality of green pixels.

For example, the transparent quantum dot (QD) ink 7201 (or blue quantum dot ink) may be applied to the green pixels to form the transparent layer 530B (or a blue color converter layer). When applying the quantum dot (QD) ink 7201 to the blue pixel area, the transparent quantum dot (QD) ink 7201 may be applied along a centerline B of the blue pixel. After aligning the nozzle 710 with the centerline B of the blue pixels, the nozzle may be moved in the scan direction to apply the transparent quantum dot (QD) ink 7201 to a plurality of blue pixels.

According to an embodiment, as the quantum dot (QD) ink 7201 is applied to pixels of the same color connected in the advancing direction of the nozzle 710 using the nozzle 710, a portion of the quantum dot (QD) ink 7201 may remain on the top surface of the barrier ribs 540. In this case, by adjusting the surface energy of the barrier ribs 540 and the quantum dot (QD) ink 7201, the quantum dot (QD) ink 7201 may either not substantially remain on the top surface of the barrier ribs 540 or remain in only small amounts, thereby ensuring that there is no issue in bonding the light source substrate (e.g., light source substrate 501 in FIG. 5) with the quantum dot color converter substrate 502. However, when a large amount of quantum dot (QD) ink 7201 remains on the top surface of the barrier ribs 540, defects may occur in the bonding between the light source substrate (e.g., light source substrate 501 in FIG. 5) and the quantum dot color converter substrate 502.

The manufacturing method of the display device according to an embodiment of the present disclosure may form the barrier ribs 540 to prevent defects during the bonding of the light source substrate (e.g., light source substrate 501 in FIG. 5) and the quantum dot color converter substrate 502.

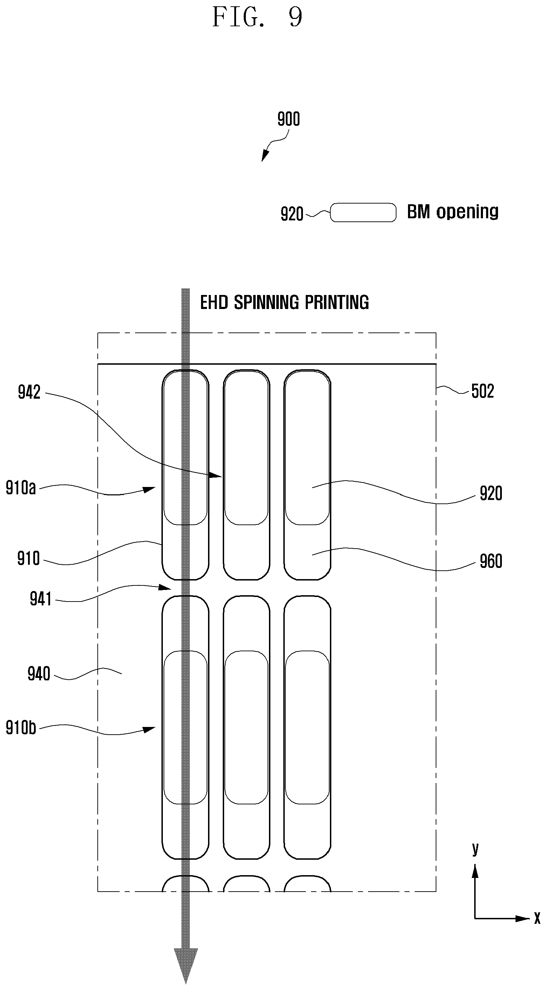

FIG. 9 is a view 900 illustrating the shape of a barrier rib formed in a quantum dot color converter substrate according to an embodiment of the present disclosure.

With reference to FIG. 9, the quantum dot color converter substrate 502 (e.g., quantum dot color converter substrate 502 in FIG. 5) according to an embodiment of the present disclosure may have barrier ribs 940 formed to separate a plurality of pixel areas 910. For example, a plurality of pixel areas 910 of the same color may be disposed in the first direction (e.g., y-axis direction or vertical direction in FIG. 9). In the second direction (e.g., x-axis direction or horizontal direction in FIG. 9), a plurality of pixel areas 910 of different colors may be disposed.

According to an embodiment, micro LED pads may be disposed in the plurality of pixel areas 910. For example, the micro LED pads may be disposed at positions corresponding to the open areas 920 (BM openings) (e.g., aperture areas). The open areas 920 (BM openings) (e.g., aperture areas) of the plurality of pixel areas 910 may be defined by the light-blocking layer 960.

According to an embodiment, the barrier ribs 940 may be formed so that the area of the pixel area 910 formed by the barrier ribs 940 (e.g., first area of the pixel area) is larger than the area of the pixel area formed by the light-blocking layer 960 (e.g., second area of the pixel area) (e.g., area of the open area). For example, the light-blocking layer 960 may be formed within the pixel area 910 formed by the barrier ribs 940.

According to an embodiment, the barrier ribs 940 may be formed so that a gap 941 between a first pixel 910a and a second pixel 910b, which are adjacent in the first direction (e.g., y-axis direction or vertical direction in FIG. 9), is narrower than a gap 942 between pixels adjacent in the second direction (e.g., x-axis direction or horizontal direction in FIG. 9).

According to an embodiment, the barrier ribs 940 may be formed so that the gap 941 between the first pixel 910a and the second pixel 910b, which are adjacent in the first direction (e.g., y-axis direction or vertical direction in FIG. 9), is the same as the gap 942 between pixels adjacent in the second direction (e.g., x-axis direction or horizontal direction in FIG. 9).

When the barrier ribs 940 may be formed so that the gap 941 between the first pixel 910a and the second pixel 910b, which are adjacent in the first direction (e.g., y-axis direction or vertical direction in FIG. 9), is formed to be the same as (or narrower than) the gap 942 between pixels adjacent in the second direction (e.g., x-axis direction or horizontal direction), the quantum dot ink (e.g., quantum dot ink 7201 in FIG. 7) may either not substantially remain (or only a small amount may remain) on the top surface of the barrier ribs 940. The top surface of the barrier ribs 940, having liquid-repellent properties, may cause the quantum dot ink (e.g., quantum dot ink 7201 in FIG. 7) to flow into the pixel area 910, resulting in substantially no quantum dot ink (e.g., quantum dot ink 7201 in FIG. 7) remaining (or a small amount remaining) on the top surface of the barrier rib 940. As the top surface of the barrier ribs 940 is formed narrower, the effect of the quantum dot ink 7201 flowing into the pixel area increases. Therefore, the bonding between the light source substrate (e.g., light source substrate 501 in FIG. 5) and the quantum dot color converter substrate 502 may be smoothly achieved.

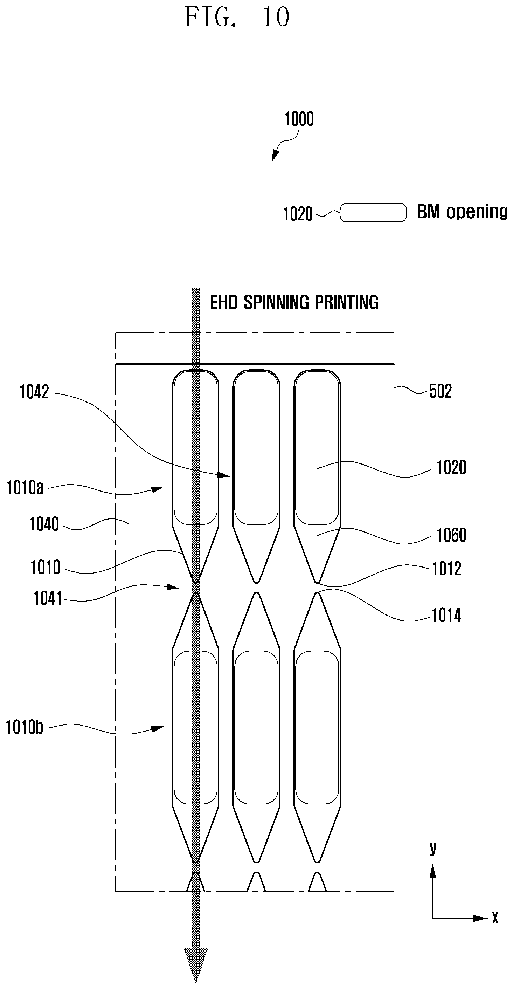

FIG. 10 is a view 1000 illustrating the shape of a barrier rib formed in a quantum dot color converter substrate according to an embodiment of the present disclosure.

With reference to FIG. 10, the quantum dot color converter substrate 502 (e.g., quantum dot color converter substrate 502 in FIG. 5) according to an embodiment of the present disclosure may have barrier ribs 1040 formed to separate a plurality of pixel areas 1010. For example, a plurality of pixel areas 1010 of the same color may be disposed in the first direction (e.g., y-axis direction or vertical direction in FIG. 10). In the second direction (e.g., x-axis direction or horizontal direction in FIG. 10), a plurality of pixel areas 1010 of different colors may be disposed.

According to an embodiment, micro LED pads may be disposed in the plurality of pixel areas 1010. For example, the micro LED pads may be disposed at positions corresponding to the open areas 1020 (BM openings) (e.g., aperture areas). The open areas 1020 (BM openings) (e.g., aperture areas) of the plurality of pixel areas 1010 may be defined by the light-blocking layer 1060.

According to an embodiment, the barrier ribs 1040 may be formed so that the area of the pixel area 1010 formed by the barrier ribs 1040 (e.g., first area of the pixel area) is larger than the area of the pixel area formed by the light-blocking layer 1060 (e.g., second area of the pixel area) (e.g., area of the open area). For example, the light-blocking layer 1060 may be formed within the pixel area 1010 formed by the barrier ribs 1040.

According to an embodiment, the barrier ribs 1040 may be formed so that the pixel areas 1010 have a hexagonal shape.

For example, the barrier ribs 1040 may be formed so that a portion adjacent to a first pixel 1010a and a second pixel 1010b, which are adjacent in the first direction (e.g., y-axis direction or vertical direction in FIG. 10), have a pointed shape.

For example, the barrier ribs 1040 may be formed so that an edge portion 1012 of the first pixel 1010a and an edge portion 1014 of the second pixel 1010b are disposed adjacent to each other.

For example, the barrier ribs 1040 may be formed so that a gap 1041 of an area adjacent to the edge portion 1012 of the first pixel 1010a and the edge portion 1012 of the second pixel 1010b, which are adjacent in the first direction (e.g., y-axis direction or vertical direction in FIG. 10), is narrower than a gap 1042 between pixels adjacent in the second direction (e.g., x-axis direction or horizontal direction).

The barrier rib of the edge portion 1012 of the first pixel 1010a and the edge portion 1014 of the second pixel 1010b, which are adjacent in the first direction (e.g., y-axis direction or vertical direction in FIG. 10), may be formed narrowly, ensuring that the quantum dot ink (e.g., quantum dot ink 7201 in FIG. 7) does not substantially remain (or only a small amount remains) on the top surface of the barrier ribs 1040. The top surface of the barrier ribs 1040, having liquid-repellent properties, may cause the quantum dot ink (e.g., quantum dot ink 7201 in FIG. 7) to flow into the pixel area 1010, resulting in substantially no quantum dot ink (e.g., quantum dot ink 7201 in FIG. 7) remaining (or a small amount remaining) on the top surface of the barrier ribs 1040. As the top surface of the barrier ribs 1040 is formed narrower, the effect of the quantum dot ink 7201 flowing into the pixel area increases. Therefore, the bonding between the light source substrate (e.g., light source substrate 501 in FIG. 5) and the quantum dot color converter substrate 502 may be smoothly achieved.

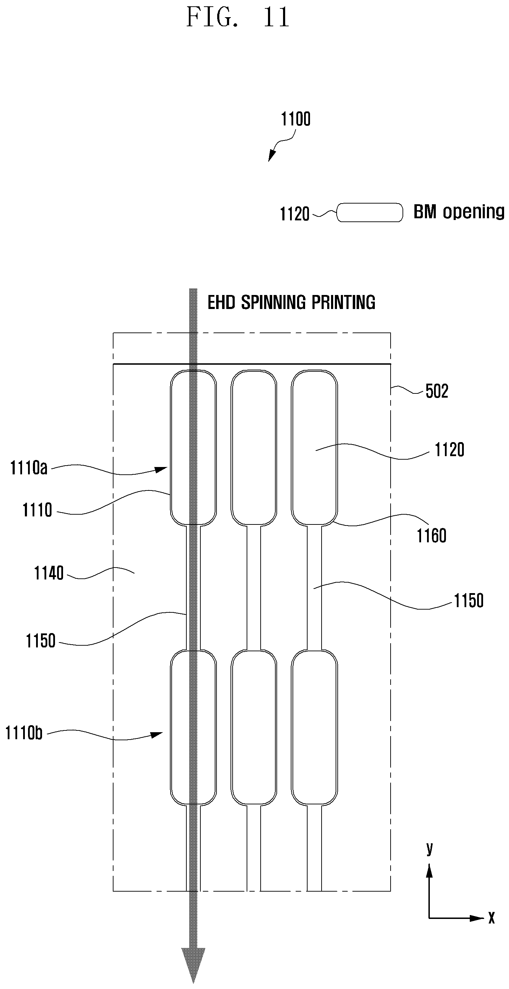

FIG. 11 is a view 1100 illustrating the shape of a barrier rib formed in a quantum dot color converter substrate according to an embodiment of the present disclosure.

With reference to FIG. 11, the quantum dot color converter substrate 502 (e.g., quantum dot color converter substrate 502 in FIG. 5) according to an embodiment of the present disclosure may have barrier ribs 1140 formed to separate a plurality of pixel areas 1110. For example, a plurality of pixel areas 1110 of the same color may be disposed in the first direction (e.g., y-axis direction or vertical direction in FIG. 11). In the second direction (e.g., x-axis direction or horizontal direction in FIG. 11), a plurality of pixel areas 1110 of different colors may be disposed.

According to an embodiment, micro LED pads may be disposed in the plurality of pixel areas 1110. For example, the micro LED pads may be disposed at positions corresponding to the open areas 1120 (BM openings) (e.g., aperture areas). The open areas 1120 (BM openings) (e.g., aperture areas) of the plurality of pixel areas 1110 may be defined by the light-blocking layer 1160.

According to an embodiment, the barrier ribs 1140 may be formed so that the area of the pixel area 1110 formed by the barrier ribs 1140 (e.g., first area of the pixel area) is larger than the area of the pixel area formed by the light-blocking layer 1160 (e.g., second area of the pixel area) (e.g., area of the open area). For example, the light-blocking layer 1160 may be formed within the pixel area 1110 formed by the barrier ribs 1140.

According to an embodiment, the barrier ribs 1140 may be formed so that a first pixel 1110a and a second pixel 1110b, which are adjacent in the first direction (e.g., y-axis direction or vertical direction in FIG. 11), are connected to each other.

For example, the barrier ribs 1140 may be formed so that a connection portion 1150 is formed to connect the first pixel 1110a and the second pixel 1110b, which are adjacent in the first direction (e.g., y-axis direction or vertical direction in FIG. 11).

For example, a width of the connection portion 1150 (e.g., first width), which connects the first pixel 1110a and the second pixel 1110b that are adjacent in the first direction (e.g., y-axis direction or vertical direction in FIG. 11), may be formed narrower than a width of the pixel area 1110 (e.g., second width).

In this manner, when the connection portion 1150 connecting the first pixel 1110a and the second pixel 1110b that are adjacent in the first direction (e.g., y-axis direction or vertical direction in FIG. 11) is formed, quantum dot ink (e.g., quantum dot ink 7201 in FIG. 7) may flow into the connection portion 1150 during the application of the quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1140. Therefore, the bonding between the light source substrate (e.g., light source substrate 501 in FIG. 5) and the quantum dot color converter substrate 502 may be smoothly achieved. Even if the first pixel 1110a and the second pixel 1110b, which are adjacent in the first direction (e.g., y-axis direction or vertical direction in FIG. 11), are connected to each other, light from the second pixel 1110b does not propagate to the first pixel 1110a. Additionally, the light-blocking layer 1160 may prevent light leakage between the first pixel 1110a and the second pixel 1110b, which are adjacent in the first direction (e.g., y-axis direction or vertical direction in FIG. 11).

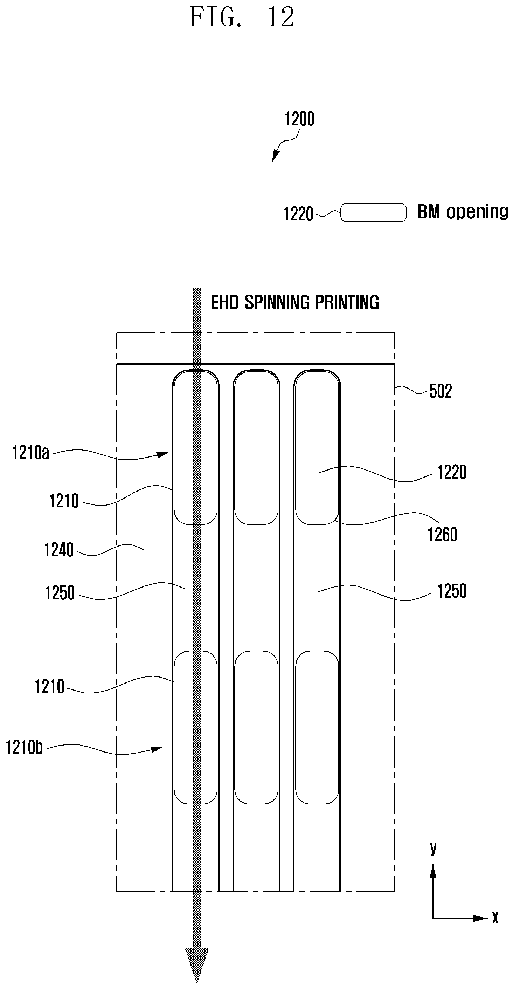

FIG. 12 is a view 1200 illustrating the shape of a barrier rib formed in a quantum dot color converter substrate according to an embodiment of the present disclosure.

With reference to FIG. 12, the quantum dot color converter substrate 502 (e.g., quantum dot color converter substrate 502 in FIG. 5) according to an embodiment of the present disclosure may have barrier ribs 1140 formed to separate a plurality of pixel areas 1210. For example, a plurality of pixel areas 1210 of the same color may be disposed in the first direction (e.g., y-axis direction or vertical direction in FIG. 12). In the second direction (e.g., x-axis direction or horizontal direction in FIG. 12), a plurality of pixel areas 1210 of different colors may be disposed.

According to an embodiment, micro LED pads may be disposed in the plurality of pixel areas 1210. For example, the micro LED pads may be disposed at positions corresponding to the open areas 1220 (BM openings) (e.g., aperture areas). The open areas 1220 (BM openings) (e.g., aperture areas) of the plurality of pixel areas 1210 may be defined by the light-blocking layer 1260.

According to an embodiment, the barrier ribs 1240 may be formed so that the area of the pixel area 1210 formed by the barrier ribs 1240 (e.g., first area of the pixel area) is larger than the area of the pixel area formed by the light-blocking layer 1260 (e.g., second area of the pixel area) (e.g., area of the open area). For example, the light-blocking layer 1260 may be formed within the pixel area 1210 formed by the barrier ribs 1240.

According to an embodiment, the barrier ribs 1240 may be formed so that a first pixel 1210a and a second pixel 1210b, which are adjacent in the first direction (e.g., y-axis direction or vertical direction in FIG. 12), are connected to each other.

For example, the barrier ribs 1240 may be formed so that a connection portion 1250 is formed to connect the first pixel 1210a and the second pixel 1210b, which are adjacent in the first direction (e.g., y-axis direction or vertical direction in FIG. 12).

For example, a width of the connection portion 1250 (e.g., first width), which connects the first pixel 1210a and the second pixel 1210b that are adjacent in the first direction (e.g., y-axis direction or vertical direction in FIG. 12), may be formed to be substantially the same as a width of the pixel area 1210 (e.g., second width).

In this manner, when the connection portion 1250 connecting the first pixel 1210a and the second pixel 1210b that are adjacent in the first direction (e.g., y-axis direction or vertical direction in FIG. 12) is formed, quantum dot ink (e.g., quantum dot ink 7201 in FIG. 7) may flow into the connection portion 1250 during the application of the quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1240. Therefore, the bonding between the light source substrate (e.g., light source substrate 501 in FIG. 5) and the quantum dot color converter substrate 502 may be smoothly achieved. Even if the first pixel 1210a and the second pixel 1210b, which are adjacent in the first direction (e.g., y-axis direction or vertical direction in FIG. 12), are connected to each other, light from the second pixel 1210b does not propagate to the first pixel 1210a. Additionally, the light-blocking layer 1260 may prevent light leakage between the first pixel 1210a and the second pixel 1210b, which are adjacent in the first direction (e.g., y-axis direction or vertical direction in FIG. 12).

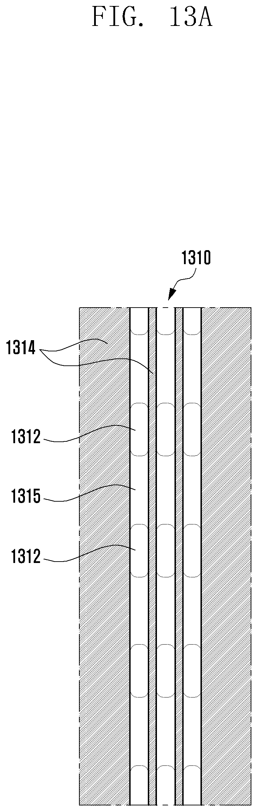

FIG. 13A is a view 1310 illustrating the shape of a barrier rib formed in a quantum dot color converter substrate according to an embodiment of the present disclosure. FIG. 13A is a top plan view illustrating the shape of the barrier ribs when viewed from above the quantum dot color converter substrate.

With reference to FIG. 13A, the quantum dot color converter substrate (e.g., quantum dot color converter substrate 502 in FIG. 5) according to an embodiment of the present disclosure may have barrier ribs 1314 formed to separate a plurality of pixel areas 1312. For example, the plurality of pixel areas 1312 of the same color may be disposed in the first direction (e.g., vertical direction in FIG. 13A). In the second direction (e.g., horizontal direction in FIG. 13A), the plurality of pixel areas 1312 of different colors may be disposed.

According to an embodiment, the barrier ribs 1314 may be formed so that the pixels adjacent in the first direction (e.g., vertical direction in FIG. 13A) are connected to each other.

For example, the barrier ribs 1314 may be formed so that a connection portion 1315 is formed to connect the pixels adjacent in the first direction (e.g., vertical direction in FIG. 13A).

For example, a width of the connection portion 1315 (e.g., first width), which connects the pixels adjacent in the first direction (e.g., vertical direction in FIG. 13A), may be formed to be substantially the same as a width of the pixel area 1312 (e.g., second width).

In this manner, when the connection portion 1315 connecting pixels adjacent in the first direction (e.g., vertical direction in FIG. 13A) is formed, the quantum dot ink (e.g., quantum dot ink 7201 in FIG. 7) may flow into the connection portion 1315 during the application of quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1314. Therefore, the bonding between the light source substrate (e.g., light source substrate 501 in FIG. 5) and the quantum dot color converter substrate 502 may be smoothly achieved. Even if the pixels adjacent in the first direction (e.g., vertical direction in FIG. 13A) are connected to each other, light does not propagate between the pixels. Additionally, the light-blocking layer (e.g., light-blocking layer 1260 in FIG. 12) may prevent light leakage between pixels adjacent in the first direction (e.g., vertical direction in FIG. 13A).

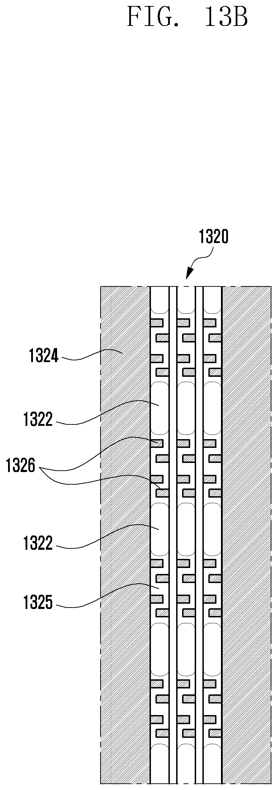

FIG. 13B is a view 1320 illustrating the shape of a barrier rib formed in a quantum dot color converter substrate according to an embodiment of the present disclosure. FIG. 13B is a top plan view illustrating the shape of the barrier ribs when viewed from above the quantum dot color converter substrate.

With reference to FIG. 13B, the quantum dot color converter substrate (e.g., quantum dot color converter substrate 502 in FIG. 5) according to an embodiment of the present disclosure may have barrier ribs 1324 formed to separate a plurality of pixel areas 1322. For example, the plurality of pixel areas 1322 of the same color may be disposed in the first direction (e.g., vertical direction in FIG. 13B). In the second direction (e.g., horizontal direction in FIG. 13B), the plurality of pixel areas 1322 of different colors may be disposed.

According to an embodiment, the barrier ribs 1324 may be formed so that the pixels adjacent in the first direction (e.g., vertical direction in FIG. 13B) are connected to each other.

For example, the barrier ribs 1324 may be formed so that a connection portion 1325 is formed to connect the pixels adjacent in the first direction (e.g., vertical direction in FIG. 13B).

For example, a width of the connection portion 1325 (e.g., first width), which connects the pixels adjacent in the first direction (e.g., vertical direction in FIG. 13B), may be formed to be substantially the same as a width of the pixel area 1322 (e.g., second width).

According to an embodiment, internal barrier ribs 1326 (internal walls) may be formed within a space of the connection portion 1325. For example, the internal barrier ribs 1326 may be formed to protrude into the space of the connection portion 1325 from the barrier ribs 1324.

In this manner, when the connection portion 1325 connecting the pixels adjacent in the first direction (e.g., vertical direction in FIG. 13B) is formed and the internal barrier ribs 1326 are formed, the quantum dot ink (e.g., quantum dot ink 7201 in FIG. 7) may flow into the connection portion 1325 during the application of quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1324. Therefore, the bonding between the light source substrate (e.g., light source substrate 501 in FIG. 5) and the quantum dot color converter substrate 502 may be smoothly achieved. Even if the pixels adjacent in the first direction (e.g., vertical direction in FIG. 13B) are connected to each other, light does not propagate between the pixels. Additionally, the light-blocking layer (e.g., light-blocking layer 1260 in FIG. 12) may prevent light leakage between pixels adjacent in the first direction (e.g., vertical direction in FIG. 13B).

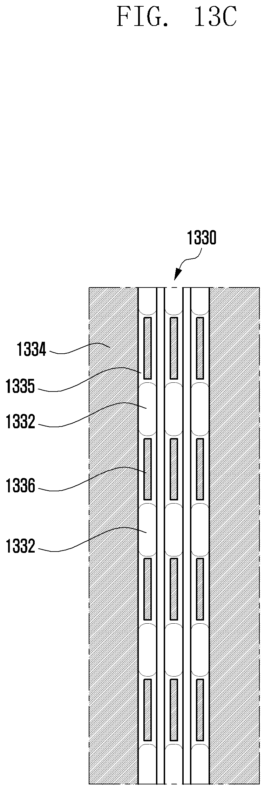

FIG. 13C is a view 1330 illustrating the shape of a barrier rib formed in a quantum dot color converter substrate according to an embodiment of the present disclosure. FIG. 13C is a top plan view illustrating the shape of the barrier ribs when viewed from above the quantum dot color converter substrate.

With reference to FIG. 13C, the quantum dot color converter substrate (e.g., quantum dot color converter substrate 502 in FIG. 5) according to an embodiment of the present disclosure may have barrier ribs 1334 formed to separate a plurality of pixel areas 1332. For example, the plurality of pixel areas 1332 of the same color may be disposed in the first direction (e.g., vertical direction in FIG. 13C). In the second direction (e.g., horizontal direction in FIG. 13C), the plurality of pixel areas 1332 of different colors may be disposed.

According to an embodiment, the barrier ribs 1334 may be formed so that the pixels adjacent in the first direction (e.g., vertical direction in FIG. 13C) are connected to each other.

For example, the barrier ribs 1334 may be formed so that a connection portion 1335 is formed to connect the pixels adjacent in the first direction (e.g., vertical direction in FIG. 13C).

For example, a width of the connection portion 1335 (e.g., first width), which connects the pixels adjacent in the first direction (e.g., vertical direction in FIG. 13C), may be formed to be substantially the same as a width of the pixel area 1332 (e.g., second width).

According to an embodiment, at least one internal barrier rib 1336 (internal wall) may be formed within a space of the connection portion 1335. For example, the internal barrier rib 1336 may be formed in the form of an island. For example, the internal barrier rib 1336 may be formed in an elongated "I" shape in the vertical direction in FIG. 13C.

In this manner, when the connection portion 1335 connecting the pixels adjacent in the first direction (e.g., vertical direction in FIG. 13C) is formed and the internal barrier rib 1336 is formed, the quantum dot ink (e.g., quantum dot ink 7201 in FIG. 7) may flow into the connection portion 1335 during the application of quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1334. Therefore, the bonding between the light source substrate (e.g., light source substrate 501 in FIG. 5) and the quantum dot color converter substrate 502 may be smoothly achieved. Even if the pixels adjacent in the first direction (e.g., vertical direction in FIG. 13C) are connected to each other, light does not propagate between the pixels. Additionally, the light-blocking layer (e.g., light-blocking layer 1260 in FIG. 12) may prevent light leakage between pixels adjacent in the first direction (e.g., vertical direction in FIG. 13C).

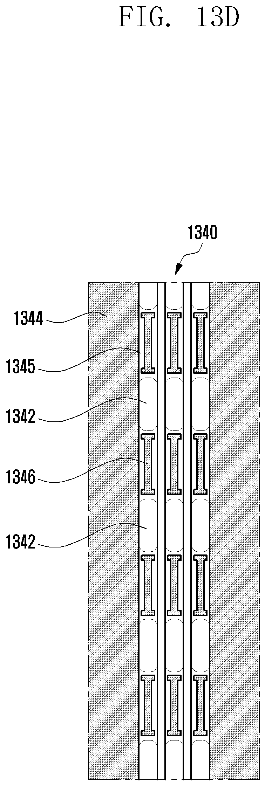

FIG. 13D is a view 1340 illustrating the shape of a barrier rib formed in a quantum dot color converter substrate according to an embodiment of the present disclosure. FIG. 13D is a top plan view illustrating the shape of the barrier ribs when viewed from above the quantum dot color converter substrate.

With reference to FIG. 13D, the quantum dot color converter substrate (e.g., quantum dot color converter substrate 502 in FIG. 5) according to an embodiment of the present disclosure may have barrier ribs 1344 formed to separate a plurality of pixel areas 1342. For example, the plurality of pixel areas 1342 of the same color may be disposed in the first direction (e.g., vertical direction in FIG. 13D). In the second direction (e.g., horizontal direction in FIG. 13D), the plurality of pixel areas 1342 of different colors may be disposed.

According to an embodiment, the barrier ribs 1344 may be formed so that the pixels adjacent in the first direction (e.g., vertical direction in FIG. 13D) are connected to each other.

For example, the barrier ribs 1344 may be formed so that a connection portion 1345 is formed to connect the pixels adjacent in the first direction (e.g., vertical direction in FIG. 13D).

For example, a width of the connection portion 1345 (e.g., first width), which connects the pixels adjacent in the first direction (e.g., vertical direction in FIG. 13D), may be formed to be substantially the same as a width of the pixel area 1342 (e.g., second width).

According to an embodiment, at least one internal barrier rib 1346 (internal wall) may be formed within a space of the connection portion 1345. For example, the internal barrier rib 1346 may be formed in the form of an island. For example, the internal barrier rib 1346 may be formed in an elongated " I " shape in the vertical direction in FIG. 13D.

In this manner, when the connection portion 1345 connecting the pixels adjacent in the first direction (e.g., vertical direction in FIG. 13D) is formed and the internal barrier rib 1346 is formed, the quantum dot ink (e.g., quantum dot ink 7201 in FIG. 7) may flow into the connection portion 1345 during the application of quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1344. Therefore, the bonding between the light source substrate (e.g., light source substrate 501 in FIG. 5) and the quantum dot color converter substrate 502 may be smoothly achieved. Even if the pixels adjacent in the first direction (e.g., vertical direction in FIG. 13D) are connected to each other, light does not propagate between the pixels. Additionally, the light-blocking layer (e.g., light-blocking layer 1260 in FIG. 12) may prevent light leakage between pixels adjacent in the first direction (e.g., vertical direction in FIG. 13D).

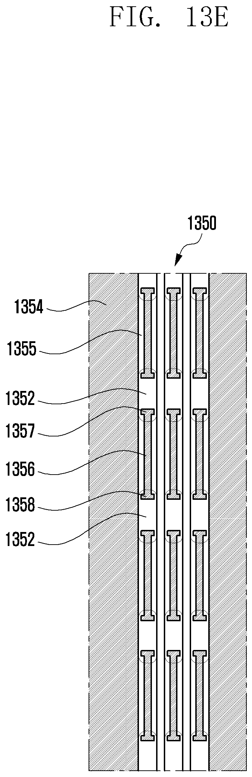

FIG. 13E is a view 1340 illustrating the shape of a barrier rib formed in a quantum dot color converter substrate according to an embodiment of the present disclosure. FIG. 13E is a top plan view illustrating the shape of the barrier ribs when viewed from above the quantum dot color converter substrate.

With reference to FIG. 13E, the quantum dot color converter substrate (e.g., quantum dot color converter substrate 502 in FIG. 5) according to an embodiment of the present disclosure may have barrier ribs 1354 formed to separate a plurality of pixel areas 1352. For example, the plurality of pixel areas 1352 of the same color may be disposed in the first direction (e.g., vertical direction in FIG. 13E). In the second direction (e.g., horizontal direction in FIG. 13E), the plurality of pixel areas 1352 of different colors may be disposed.

According to an embodiment, the barrier ribs 1354 may be formed so that the pixels adjacent in the first direction (e.g., vertical direction in FIG. 13E) are connected to each other.

For example, the barrier ribs 1354 may be formed so that a connection portion 1355 is formed to connect the pixels adjacent in the first direction (e.g., vertical direction in FIG. 13E).

For example, a width of the connection portion 1355 (e.g., first width), which connects the pixels adjacent in the first direction (e.g., vertical direction in FIG. 13E), may be formed to be substantially the same as a width of the pixel area 1352 (e.g., second width).

According to an embodiment, at least one internal barrier rib 1356 (internal wall) may be formed within a space of the connection portion 1355. For example, the internal barrier rib 1356 may be formed in the form of an island. For example, the internal barrier rib 1356 may be formed in an elongated " I " shape in the vertical direction in FIG. 13E.

For example, a first side 1357 of the internal barrier rib 1356 may also be disposed in a portion of a first pixel area. For example, a second side 1358 of the internal barrier rib 1356 may be disposed in a portion of a second pixel area that is adjacent to the first pixel area vertically.

For example, the pixels that are adjacent in the first direction (e.g., vertical direction in FIG. 13E) may be connected to each other by the internal barrier rib 1356.

In this manner, when the connection portion 1355 connecting the pixels adjacent in the first direction (e.g., vertical direction in FIG. 13E) is formed and the internal barrier rib 1356 is formed, the quantum dot ink (e.g., quantum dot ink 7201 in FIG. 7) may flow into the connection portion 1355 during the application of quantum dot ink (e.g., quantum dot ink 7201 in FIG. 7). Therefore, it is possible to ensure that substantially no quantum dot ink (e.g., quantum dot ink 7201 in FIG. 7) remains (or a small amount remains) on the top surface of the barrier rib 1354. Therefore, the bonding between the light source substrate (e.g., light source substrate 501 in FIG. 5) and the quantum dot color converter substrate 502 may be smoothly achieved. Even if the pixels adjacent in the first direction (e.g., vertical direction in FIG. 13E) are connected to each other, light does not propagate between the pixels. Additionally, the light-blocking layer (e.g., light-blocking layer 1260 in FIG. 12) may prevent light leakage between pixels adjacent in the first direction (e.g., vertical direction in FIG. 13E).

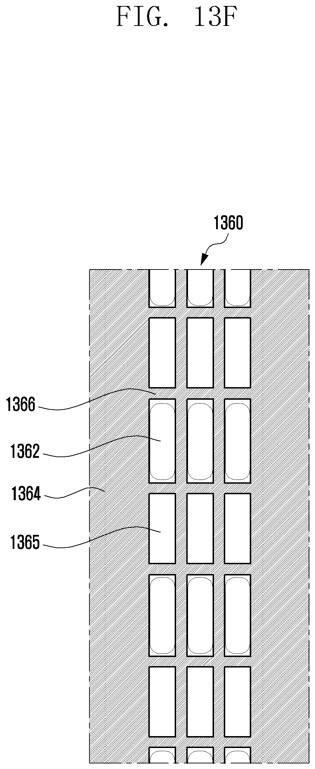

FIG. 13F is a view 1360 illustrating the shape of a barrier rib formed in a quantum dot color converter substrate according to an embodiment of the present disclosure. FIG. 13F is a top plan view illustrating the shape of the barrier ribs when viewed from above the quantum dot color converter substrate.

With reference to FIG. 13F, the quantum dot color converter substrate (e.g., quantum dot color converter substrate 502 in FIG. 5) according to an embodiment of the present disclosure may have barrier ribs 1364 and 1366 formed to separate a plurality of pixel areas 1362 and dummy areas 1365.

For example, the plurality of pixel areas 1332 of the same color may be disposed in the first direction (e.g., vertical direction in FIG. 13F). In the second direction (e.g., horizontal direction in FIG. 13F), the plurality of pixel areas 1332 of different colors may be disposed.

For example, the barrier ribs 1364 and 1366 may separate the pixel areas 1362 that are adjacent in the first direction (e.g., vertical direction in FIG. 13F).

For example, the barrier ribs 1364 and 1366 may separate a plurality of pixel areas 1332 of different colors in the second direction (e.g., horizontal direction in FIG. 13F).

For example, the dummy area 1365 may be disposed between the pixel areas 1362 that are adjacent in the first direction (e.g., vertical direction in FIG. 13F).

For example, a width of the dummy area 1365 (e.g., first width) disposed between the pixel areas 1362 that are adjacent in the first direction (e.g., vertical direction in FIG. 13C) may be formed to be substantially the same as a width of the pixel area 1332 (e.g., second width).

During the application of quantum dot ink (e.g., quantum dot ink 7201 in FIG. 7), the quantum dot ink (e.g., quantum dot ink 7201 in FIG. 7) may flow into the dummy area 1365. Therefore, it is possible to ensure that substantially no quantum dot ink (e.g., quantum dot ink 7201 in FIG. 7) remains (or a small amount remains) on the top surfaces of the barrier ribs 1364 and 1366. Therefore, the bonding between the light source substrate (e.g., light source substrate 501 in FIG. 5) and the quantum dot color converter substrate 502 may be smoothly achieved.

Since the dummy area 1365 is disposed between the pixels adjacent in the first direction (e.g., vertical direction in FIG. 13F), light does not propagate between the pixels. Additionally, the light-blocking layer (e.g., light-blocking layer 1260 in FIG. 12) may prevent light leakage between pixels adjacent in the first direction (e.g., vertical direction in FIG. 13C).

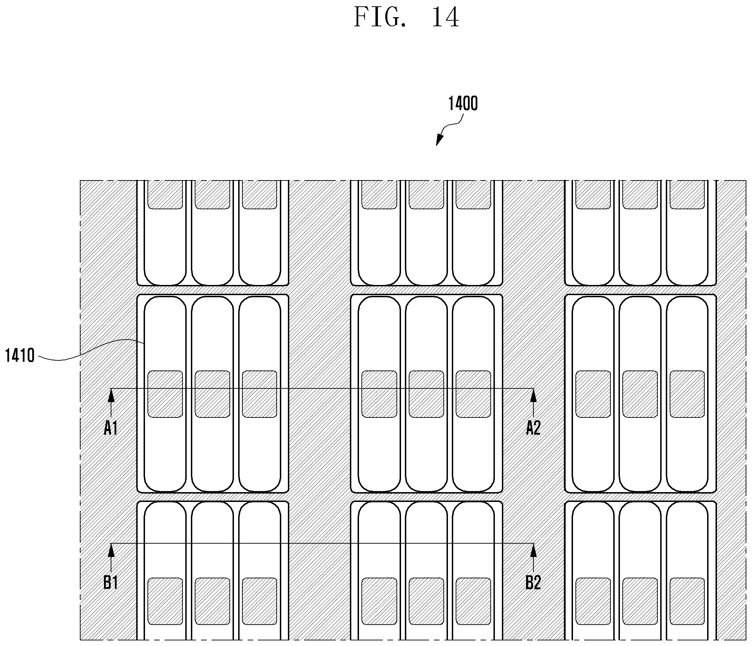

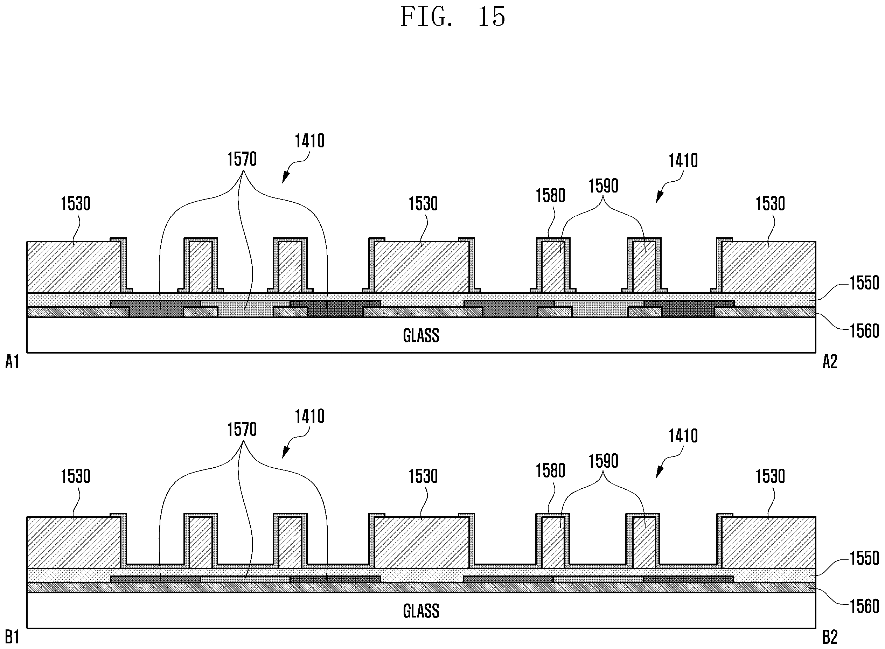

FIG. 14 is a top plan view illustrating a barrier rib formed on a quantum dot color converter substrate and a conductive layer formed on top of the barrier rib, according to an embodiment of the present disclosure. FIG. 15 is a cross-sectional view taken along line A1-A2 and line B1-B2 illustrated in FIG. 14.

With reference to FIGS. 14 and 15, the display (e.g., display 500 in FIG. 5) according to an embodiment of the present disclosure may include a light source substrate (e.g., light source substrate 501 in FIG. 5) and a quantum dot color converter substrate 1400 (e.g., quantum dot color converter substrate 502 in FIG. 5).

According to an embodiment, a quantum dot color converter substrate 1400 may include a quantum dot (QD) color converter layer (e.g., quantum dot color converter layer 530 in FIG. 5), barrier ribs 1530 (e.g., barrier ribs 540 in FIG. 5), a planarization layer 1550 (e.g., planarization layer 550 in FIG. 5), a light-blocking layer 1560 (e.g., light-blocking layer 560 in FIG. 5) (e.g., a black matrix (BM)), a color filter layer 1570 (e.g., color filter layer 570 in FIG. 5), a conductive layer 1580, and a transparent substrate (e.g., transparent substrate 580 in FIG. 5). FIGS. 14 and 15 illustrate states during the manufacturing process of the quantum dot color converter substrate 1400, and the quantum dot (QD) color converter layer (e.g., quantum dot color converter layer 530 in FIG. 5) is not illustrated.

According to an embodiment, the barrier ribs 1350 may separate the areas of each pixel. The light-blocking layer 1560 may be disposed between the color filter layers 1570 of each pixel to prevent color mixing between pixels and to separate the area of each pixel. The transparent substrate (e.g., transparent glass) may be disposed on top of the color filter layer 1570.

According to an embodiment, the conductive layer 1580 may be disposed on top of the barrier ribs 1530.

According to an embodiment, light generated from the quantum dot (QD) color converter layer (e.g., quantum dot color converter layer 530 in FIG. 5) may be reflected within the pixel by the conductive layer 1580, thereby enhancing the light emission efficiency.

According to an embodiment, the conductive layer 1580 may also be formed on top of the barrier ribs 1314, as illustrated in FIG. 13A. For example, when the conductive layer 1580 is formed on top of the barrier ribs 1314, as illustrated in FIG. 13A, it is possible to secure light reflective areas on the left and right sides of the pixel, thereby enhancing the light emission efficiency of the pixel.

According to an embodiment, the conductive layer 1580 may also be formed on top of the barrier ribs 1324 and the internal barrier ribs 1326, as illustrated in FIG. 13B. For example, when the conductive layer 1580 is formed on top of the barrier ribs 1324 and the internal barrier ribs 1326, as illustrated in FIG. 13B, it is possible to secure light reflective areas on the left, right, top, and bottom sides of the pixel, thereby enhancing the light emission efficiency of the pixel.

According to an embodiment, the conductive layer 1580 may also be formed on top of the barrier ribs 1334 and the internal barrier ribs 1336, as illustrated in FIG. 13C. For example, when the conductive layer 1580 is formed on top of the barrier ribs 1334 and the internal barrier ribs 1336, as illustrated in FIG. 13C, it is possible to secure light reflective areas on the left, right, top, and bottom sides of the pixel, thereby enhancing the light emission efficiency of the pixel.

According to an embodiment, the conductive layer 1580 may also be formed on top of the barrier ribs 1344 and the internal barrier ribs 1346, as illustrated in FIG. 13D. For example, when the conductive layer 1580 is formed on top of the barrier ribs 1344 and the internal barrier ribs 1346, as illustrated in FIG. 13D, it is possible secure light reflective areas on the left, right, top, and bottom sides of the pixel, thereby enhancing the light emission efficiency of the pixel.

According to an embodiment, the conductive layer 1580 may also be formed on top of the barrier ribs 1354 and the internal barrier ribs 1356, as illustrated in FIG. 13E. For example, when the conductive layer 1580 is formed on top of the barrier ribs 1354 and the internal barrier ribs 1356, as illustrated in FIG. 13E, it is possible to secure light reflective areas on the left, right, top, and bottom sides of the pixel, thereby enhancing the light emission efficiency of the pixel.

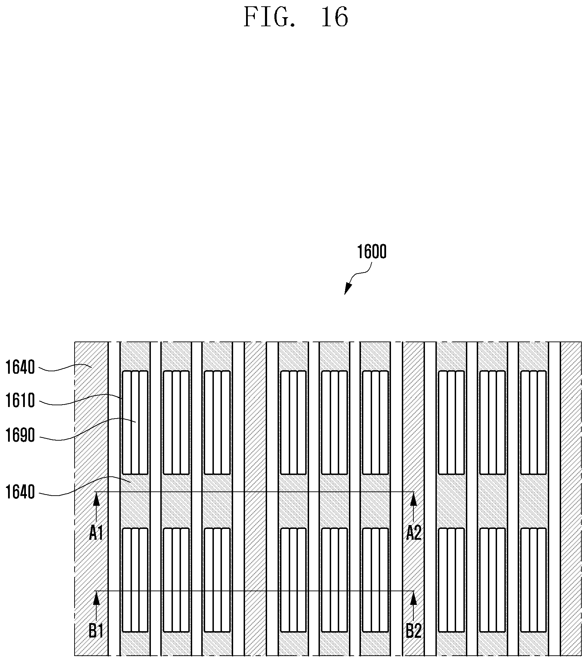

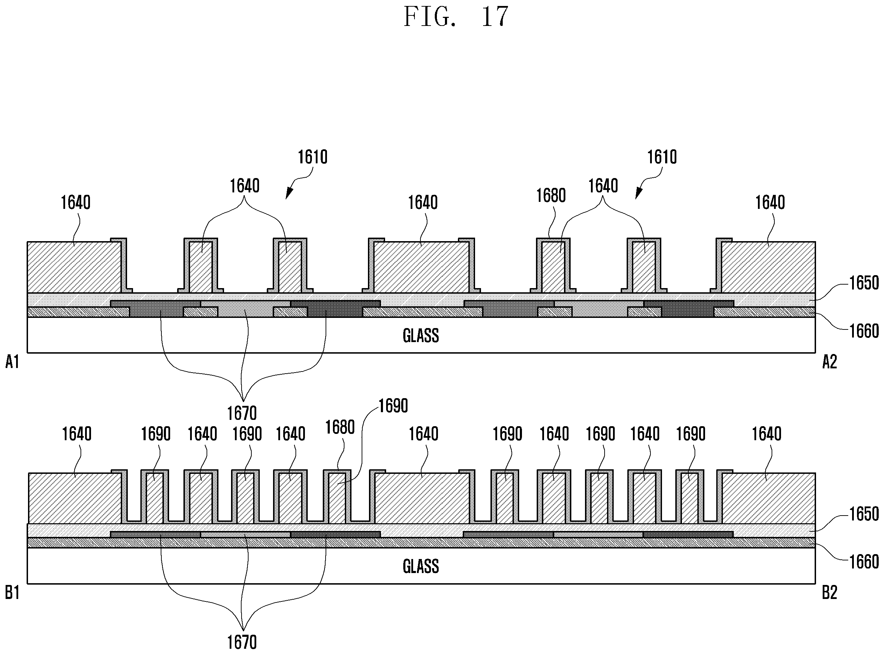

FIG. 16 is a top plan view illustrating a barrier rib formed on a quantum dot color converter substrate and a conductive layer formed on top of the barrier rib, according to an embodiment of the present disclosure. FIG. 17 is a cross-sectional view taken along line A1-A2 and line B1-B2 illustrated in FIG. 16.

With reference to FIGS. 16 and 17, the display (e.g., display 500 in FIG. 5) according to an embodiment of the present disclosure may include a light source substrate (e.g., light source substrate 501 in FIG. 5) and a quantum dot color converter substrate 1600 (e.g., quantum dot color converter substrate 502 in FIG. 5).

According to an embodiment, a quantum dot color converter substrate 1600 may include a quantum dot (QD) color converter layer (e.g., quantum dot color converter layer 530 in FIG. 5), barrier ribs 1640 (e.g., barrier ribs 540 in FIG. 5), a planarization layer 1650 (e.g., planarization layer 550 in FIG. 5), a light-blocking layer 1660 (e.g., light-blocking layer 560 in FIG. 5) (e.g., a black matrix (BM)), a color filter layer 1670 (e.g., color filter layer 570 in FIG. 5), a conductive layer 1680, internal barrier ribs 1690, and a transparent substrate (e.g., transparent substrate 580 in FIG. 5). For example, the barrier ribs 1640 may separate a plurality of pixel areas 1610. FIGS. 16 and 17 illustrate states during the manufacturing process of the quantum dot color converter substrate 1600, and the quantum dot (QD) color converter layer (e.g., quantum dot color converter layer 530 in FIG. 5) is not illustrated.

According to an embodiment, the barrier ribs 1640 may separate the areas of each pixel. The light-blocking layer 1660 may be disposed between the color filter layers 1670 of each pixel to prevent color mixing between pixels and to separate the area of each pixel. The transparent substrate (e.g., transparent glass) may be disposed on top of the color filter layer 1670.

According to an embodiment, the conductive layer 1680 may be disposed on top of the barrier ribs 1640.

According to an embodiment, light generated from the quantum dot (QD) color converter layer (e.g., quantum dot color converter layer 530 in FIG. 5) may be reflected within the pixel by the conductive layer 1680, thereby enhancing the light emission efficiency.

According to an embodiment, the conductive layer 1680 may be formed on top of the barrier ribs 1640 and the internal barrier ribs 1690. For example, the internal barrier rib 1690 may be formed in an elongated "I" shape in the first direction (e.g., vertical direction in FIG. 16).

When the conductive layer 1680 is formed on top of the barrier ribs 1640 and the internal barrier ribs 1690, it is possible to secure light reflective areas on the left, right, top, and bottom sides of the pixel, thereby enhancing the light emission efficiency of the pixel.

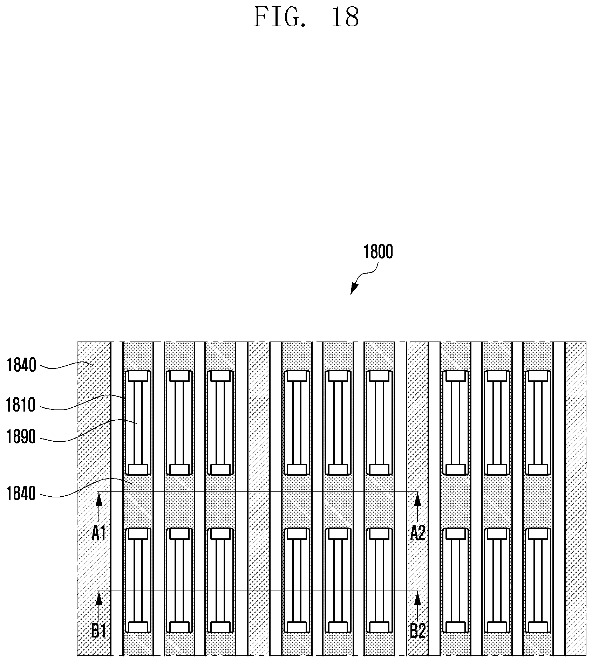

FIG. 18 is a top plan view illustrating a barrier rib formed on a quantum dot color converter substrate and a conductive layer formed on top of the barrier rib, according to an embodiment of the present disclosure.

With reference to FIGS. 17 and 18, the display (e.g., display 500 in FIG. 5) according to an embodiment of the present disclosure may include a light source substrate (e.g., light source substrate 501 in FIG. 5) and a quantum dot color converter substrate 1800 (e.g., quantum dot color converter substrate 502 in FIG. 5).

In an embodiment, a quantum dot color converter substrate 1800 may include a quantum dot (QD) color converter layer (e.g., quantum dot color converter layer 530 in FIG. 5), barrier ribs 1840 (e.g., barrier ribs 540 in FIG. 5), a planarization layer (e.g., planarization layer 550 in FIG. 5), a light-blocking layer (e.g., light-blocking layer 560 in FIG. 5) (e.g., a black matrix (BM)), a color filter layer (e.g., color filter layer 570 in FIG. 5), a conductive layer (e.g., conductive layer 1680 in FIG. 17), internal barrier ribs 1890 (e.g., internal barrier ribs 1690 in FIGS. 16 and 17), and a transparent substrate (e.g., transparent substrate 580 in FIG. 5). For example, the barrier ribs 1840 may separate a plurality of pixel areas 1810. FIG. 18 illustrates the state during the manufacturing process of the quantum dot color converter substrate 1800, where the quantum dot (QD) color converter layer (e.g., quantum dot color converter layer 530 in FIG. 5), planarization layer (e.g., planarization layer 550 in FIG. 5), light-blocking layer (e.g., light-blocking layer 560 in FIG. 5) (e.g., a black matrix(BM)), and color filter layer (e.g., color filter layer 570 in FIG. 5) are not illustrated.

According to an embodiment, the barrier rib 1840 may separate the areas 1810 of each pixel.

According to an embodiment, the conductive layer (e.g., conductive layer 1680 in FIG. 17) may be disposed on top of the barrier ribs 1840.

According to an embodiment, light generated from the quantum dot (QD) color converter layer (e.g., quantum dot color converter layer 530 in FIG. 5) may be reflected within the pixel by the conductive layer 1880, thereby enhancing the light emission efficiency.

According to an embodiment, the conductive layer (e.g., conductive layer 1680 in FIG. 17) may be formed on top of the barrier ribs 1840 and the internal barrier ribs 1890. For example, the internal barrier rib 1890 may be formed in an elongated " I " shape in the first direction (e.g., vertical direction in FIG. 18).

When the conductive layer (e.g., conductive layer 1680 in FIG. 17) is formed on top of the barrier ribs 1840 and the internal barrier ribs 1890, it is possible to secure light reflective areas on the left, right, top, and bottom sides of the pixel, thereby enhancing the light emission efficiency of the pixel.

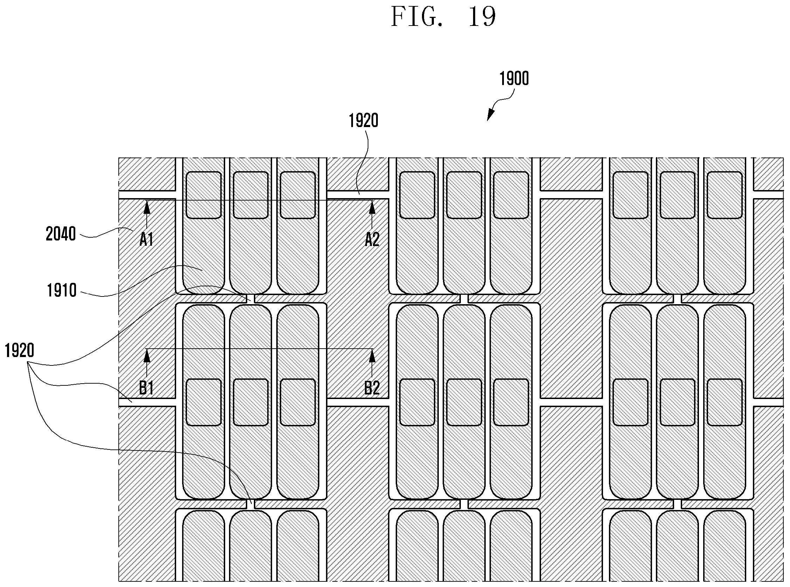

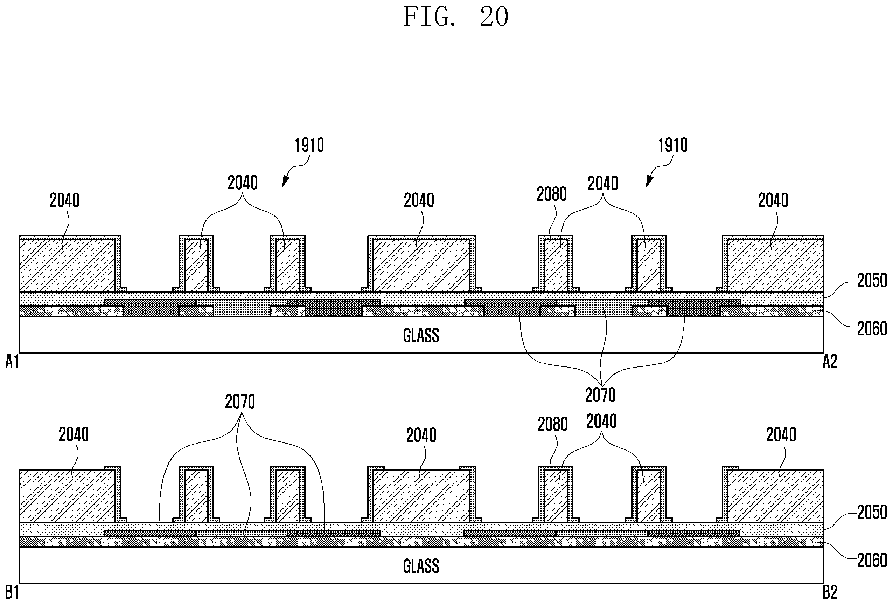

FIG. 19 is a top plan view illustrating a barrier rib formed on a quantum dot color converter substrate and a conductive layer formed on top of the barrier rib, according to an embodiment of the present disclosure. FIG. 20 is a cross-sectional view taken along line A1-A2 and line B1-B2 illustrated in FIG. 19.

With reference to FIGS. 19 and 20, the display (e.g., display 500 in FIG. 5) according to an embodiment of the present disclosure may include a light source substrate (e.g., light source substrate 501 in FIG. 5) and a quantum dot color converter substrate 1900 (e.g., quantum dot color converter substrate 502 in FIG. 5).

According to an embodiment, a quantum dot color converter substrate 1900 may include a quantum dot (QD) color converter layer (e.g., quantum dot color converter layer 530 in FIG. 5), barrier ribs 2040 (e.g., barrier ribs 540 in FIG. 5), a planarization layer 2050 (e.g., planarization layer 550 in FIG. 5), a light-blocking layer 2060 (e.g., light-blocking layer 560 in FIG. 5) (e.g., a black matrix (BM)), a color filter layer 2070 (e.g., color filter layer 570 in FIG. 5), a conductive layer 2080 (e.g., conductive layer 1680 in FIG. 17), and a transparent substrate (e.g., transparent substrate 580 in FIG. 5). FIGS. 19 and 20 illustrate states during the manufacturing process of the quantum dot color converter substrate 1900, and the quantum dot (QD) color converter layer (e.g., quantum dot color converter layer 530 in FIG. 5) is not illustrated.

According to an embodiment, the barrier rib 2040 may separate the areas 1910 of each pixel.

According to an embodiment, the conductive layer 2080 (e.g., conductive layer 1680 in FIG. 17) may be disposed on top of the barrier ribs 2040. For example, the conductive layers 2080 disposed in each pixel area 1910 (e.g., conductive layer 1680 in FIG. 17) may be electrically connected at least in part through contact portions 1920, so that the entire conductive layer 2080 (e.g., conductive layer 1680 in FIG. 17) is electrically connected.

According to an embodiment, light generated from the quantum dot (QD) color converter layer (e.g., quantum dot color converter layer 530 in FIG. 5) may be reflected within the pixel by the conductive layer 2080, thereby enhancing the light emission efficiency.

According to an embodiment, the conductive layer 2080 (e.g., conductive layer 1680 in FIG. 17) may be formed on top of the barrier ribs 2040 and the internal barrier ribs 2090. For example, the internal barrier rib 2090 may be formed in an elongated "I" or " I " shape in the first direction (e.g., vertical direction in FIG. 18). When the conductive layer 2080 (e.g., conductive layer 1680 in FIG. 17) is formed on top of the barrier ribs 2040 and the internal barrier ribs 2090, it is possible to secure light reflective areas on the left, right, top, and bottom sides of the pixel, thereby enhancing the light emission efficiency of the pixel.

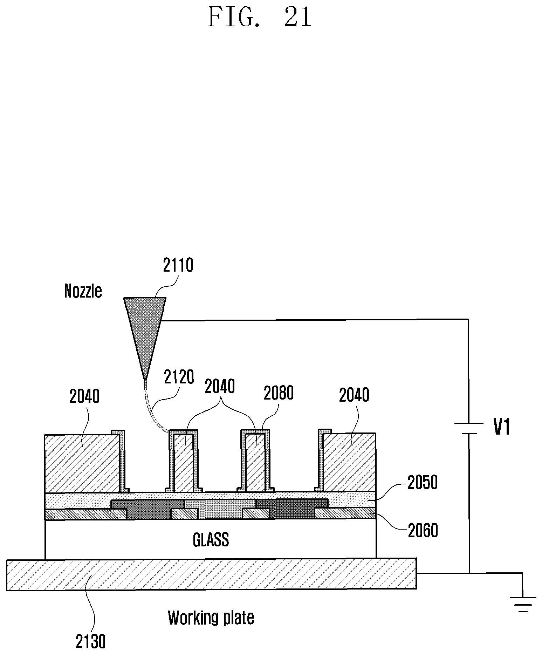

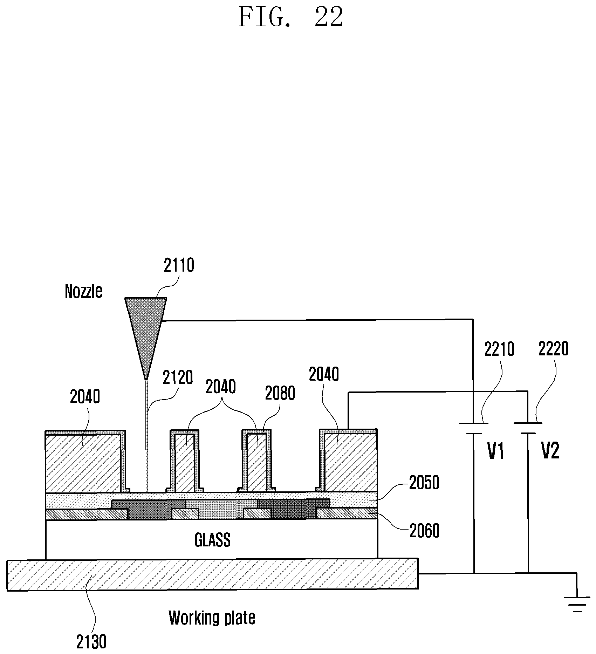

FIGS. 21 and 22 are views illustrating a method of forming a quantum dot color converter layer.

With reference to FIG. 21, the conductive layer 2080 may be formed on top of the barrier ribs 2040 and the internal barrier ribs 2090. In order to form the quantum dot color converter layer, quantum dot ink 2120 may be applied to the pixel area using a nozzle 2110. In this case, the quantum dot color converter substrate may be disposed on a working plate 2130, and a voltage V1 may be applied to the nozzle 2110. When the voltage V1 is applied to the nozzle 2110, a lifting force may be generated by the conductive layer 2080 formed on the barrier ribs 2040 and the internal barrier ribs 2090. When a lifting force is generated on the conductive layer 2080, the quantum dot ink 2120 may be drawn toward the conductive layer 2080. When the quantum dot ink 2120 is drawn toward the conductive layer 2080, the quantum dot ink 2120 may be applied to the pixel area by climbing along the walls of the conductive layer 2080.

With reference to FIG. 22, the conductive layer 2080 may be formed on top of the barrier ribs 2040 and the internal barrier ribs 2090. In order to form the quantum dot color converter layer, quantum dot ink 2120 may be applied to the pixel area using a nozzle 2110. In this case, the quantum dot color converter substrate may be disposed on the working plate 2130, a first voltage V1 may be applied to the conductive layer 2890, and a second voltage V2 may be applied to the nozzle 2110. When the first voltage V1 is applied to the conductive layer 2890 and the second voltage V2 is applied to the nozzle 2110, the quantum dot ink 2120 may be applied to the center of the pixel.

For example, in order to prevent the quantum dot ink 2120 from being drawn toward the conductive layer 2080, the first voltage V1 may be applied with a voltage larger than the second voltage V2 (e.g., V1 > V2).

For example, the first voltage V1 may have a first phase, and the second voltage V2 may have a second phase opposite to the first phase of the first voltage. For example, when the polarity (+, -) of the second voltage V2 applied to the conductive layer 2080 and the polarity (+, -) of the first voltage V1 applied to the nozzle 2110 are oppositely formed, a repulsive force may be generated on the surface of the barrier rib, while an attractive force may be formed on the bottom surface. Due to the surface where the attractive force is oppositely formed, the quantum dot ink 2120 is not drawn toward the conductive layer 2080 but instead is applied to the center of the pixel.

For example, a voltage greater than the second voltage V2 may be applied as the first voltage V1. In the surface where the polarity (+, -) of the second voltage V2 applied to the conductive layer 2080 and the polarity (+, -) of the first voltage V1 applied to the nozzle 2110 are formed, a repulsive force may be formed. When a repulsive force is formed in the surface where the polarity (+, -) of the first voltage V1 and the polarity (+, -) of the second voltage V2 are formed, the quantum dot ink 2120 may not be drawn toward the conductive layer 2080 and applied to the center of the pixel.

A display 500 according to an embodiment of the present disclosure, in a micro light emitting diode (LED) display (e.g., display 500 in FIG. 5), may include: a barrier rib (e.g., barrier ribs 540 in FIG. 5) forming a pixel area (e.g., pixel area 910 in FIG. 9, pixel area 1010 in FIG. 10, pixel area 1110 in FIG. 11, pixel area 1210 in FIG. 12, pixel area 1312 in FIG. 13A, pixel area 1322 in FIG. 13B, pixel area 1332 in FIG. 13C, pixel area 1342 in FIG. 13D, pixel area 1352 in FIG. 13E, pixel area 1362 in FIG. 13F, pixel area 1610 in FIG. 16, pixel area 1810 in FIG. 18, or pixel area 1910 in FIG. 19); a micro LED disposed in the pixel area 910, 1010, 1110, 1210, 1312, 1322, 1332, 1342, 1352, 1362, 1610, 1810, or 1910; a light-blocking portion defining an open area (e.g., open area 920 in FIG. 9, open area 1020 in FIG. 10, open area 1120 in FIG. 11, or open area 1220 in FIG. 12) of the pixel area 910, 1010, 1110, 1210, 1312, 1322, 1332, 1342, 1352, 1362, 1610, 1810, or 1910; a quantum dot color converter layer (e.g., quantum dot color converter layer 530 in FIG. 5) formed in the pixel area 910, 1010, 1110, 1210, 1312, 1322, 1332, 1342, 1352, 1362, 1610, 1810, or 1910; and a color filter layer (e.g., color filter layer 570 in FIG. 5, color filter layer 1570 in FIG. 15, color filter layer 1670 in FIG. 16, or color filter layer 2070 in FIG. 20) disposed to correspond to the quantum dot color converter layer 530. An area of the pixel area 910, 1010, 1110, 1210, 1312, 1322, 1332, 1342, 1352, 1362, 1610, 1810, or 1910 may be formed to be larger than an area of the open area 920, 1020, 1120, or 1220. A first gap between adjacent pixel areas 910, 1010, 1110, 1210, 1312, 1322, 1332, 1342, 1352, 1362, 1610, 1810, or 1910 in the first direction may be formed to be narrower than a second gap between adjacent pixels in the second direction, which is perpendicular to the first direction.

According to an embodiment, the pixel area 910, 1010, 1110, 1210, 1312, 1322, 1332, 1342, 1352, 1362, 1610, 1810, or 1910 adjacent in the first direction may be formed in the form of a hexagon with narrow edges.

According to an embodiment, a first width of the barrier rib 540 between the pixel areas 910, 1010, 1110, 1210, 1312, 1322, 1332, 1342, 1352, 1362, 1610, 1810, or 1910 adjacent in the first direction may be formed narrower than a second width of the barrier rib 540 between pixels adjacent in the second direction.

According to an embodiment, the display may include a connection portion connecting a first pixel area 910, 1010, 1110, 1210, 1312, 1322, 1332, 1342, 1352, 1362, 1610, 1810, or 1910 and a second pixel area 910, 1010, 1110, 1210, 1312, 1322, 1332, 1342, 1352, 1362, 1610, 1810, or 1910 that are adjacent in the first direction.

According to an embodiment, a first width of the connection portion may be formed narrower than a second width of the first pixel area 910, 1010, 1110, 1210, 1312, 1322, 1332, 1342, 1352, 1362, 1610, 1810, or 1910.

According to an embodiment, a width of the connection portion may be formed to be substantially the same as a width of the first pixel area 910, 1010, 1110, 1210, 1312, 1322, 1332, 1342, 1352, 1362, 1610, 1810, or 1910.

According to an embodiment, the display may include at least one internal barrier rib (e.g., internal barrier rib 1336 in FIG. 13C, internal barrier rib 1346 in FIG. 13D, internal barrier rib 1356 in FIG. 13E) disposed in the connection portion.

According to an embodiment, the at least one internal barrier rib 1336, 1346, or 1356 may be formed to protrude in a direction of the connection portion from the barrier rib 1334.

According to an embodiment, the at least one internal barrier rib 1336, 1346, or 1356 may be formed in the form of an island within the connection portion.

According to an embodiment, the at least one internal barrier rib 1346 may be formed, within the connection portion, in an elongated "I" or " I " shape in the first direction.

According to an embodiment, a first side of the at least one internal barrier rib 1336, 1346, or 1356 may be disposed on at least a portion of the first pixel area 910, 1010, 1110, 1210, 1312, 1322, 1332, 1342, 1352, 1362, 1610, 1810, or 1910, and a second side of the at least one internal barrier rib may be disposed on at least a portion of the second pixel area 910, 1010, 1110, 1210, 1312, 1322, 1332, 1342, 1352, 1362, 1610, 1810, or 1910.

According to an embodiment, the display may include a conductive layer disposed on at least one of a top surface, side surface, or bottom surface of the barrier rib 540.

According to an embodiment, the display may include a conductive layer disposed on at least one of a top surface, side surface, and bottom surface of the internal barrier rib 1336, 1346, or 1356.

A method of manufacturing a display 500 according to an embodiment of the present disclosure, in a method of manufacturing a micro light emitting diode (LED) display 500, may include: forming a barrier rib 540 defining a pixel area 910, 1010, 1110, 1210, 1312, 1322, 1332, 1342, 1352, 1362, 1610, 1810, or 1910 on a substrate; forming a light-blocking portion defining an open area 920, 1020, 1120, or 1220 of the pixel area 910, 1010, 1110, 1210, 1312, 1322, 1332, 1342, 1352, 1362, 1610, 1810, or 1910; forming a quantum dot color converter layer 530 in the pixel area 910, 1010, 1110, 1210, 1312, 1322, 1332, 1342, 1352, 1362, 1610, 1810, or 1910; forming a color filter layer 570, 1570, 1670, or 2070 to correspond to the quantum dot color converter layer, in which an area of the pixel area 910, 1010, 1110, 1210, 1312, 1322, 1332, 1342, 1352, 1362, 1610, 1810, or 1910 may be formed larger than an area of the open area 920, 1020, 1120, or 1220, and a first gap between the pixel areas 910, 1010, 1110, 1210, 1312, 1322, 1332, 1342, 1352, 1362, 1610, 1810, or 1910 adjacent in a first direction may be formed narrower than a second gap between pixels adjacent in a second direction perpendicular to the first direction.

According to an embodiment, the pixel area 910, 1010, 1110, 1210, 1312, 1322, 1332, 1342, 1352, 1362, 1610, 1810, or 1910 adjacent in the first direction may be formed in the form of a hexagon with narrow edges.

According to an embodiment, a first width of the barrier rib 540 between the pixel areas 910, 1010, 1110, 1210, 1312, 1322, 1332, 1342, 1352, 1362, 1610, 1810, or 1910 adjacent in the first direction may be formed narrower than a second width of the barrier rib 540 between pixels adjacent in the second direction.

According to an embodiment, a connection portion may formed that connects a first pixel area 910, 1010, 1110, 1210, 1312, 1322, 1332, 1342, 1352, 1362, 1610, 1810, or 1910 and a second pixel area 910, 1010, 1110, 1210, 1312, 1322, 1332, 1342, 1352, 1362, 1610, 1810, or 1910 that are adjacent in the first direction.

According to an embodiment, a first width of the connection portion may be formed narrower than a second width of the first pixel area 910, 1010, 1110, 1210, 1312, 1322, 1332, 1342, 1352, 1362, 1610, 1810, or 1910.

The display and the method of manufacturing the same, according to an embodiment of the present disclosure, may form the barrier rib so that when the quantum dot color converter layer of the display is formed by EHD spinning, the quantum dot ink does not substantially remain on the top surface of the barrier rib. Therefore, the bonding between the light source substrate and the quantum dot color converter substrate can be smoothly achieved.

The display and the method of manufacturing the same, according to an embodiment of the present disclosure may prevent light leakage between a first pixel and a second pixel that are adjacent in the first direction (e.g., y-axis direction, vertical direction).

The display and the method of manufacturing the same, according to an embodiment of the present disclosure may form a barrier rib so that the quantum dot ink is ejected to the center of the pixel, thereby ensuring that the quantum dot ink does not substantially remain on the top surface of the barrier rib. Therefore, by ensuring smooth bonding between the light source substrate and the quantum dot color converter substrate, the quality of the product can be improved.

The micro LED display and the method of manufacturing the same, according to an embodiment of the present disclosure can reduce the manufacturing cost of the product.

## Claims

1. A display, in a micro light emitting diode (LED) display, comprising:
a barrier rib forming a pixel area;
a micro LED disposed in the pixel area;
a light-blocking portion defining an open area of the pixel area;
a quantum dot color converter layer formed in the pixel area; and
a color filter layer disposed to correspond to the quantum dot color converter layer,
wherein an area of the pixel area is formed larger than an area of the open area, and
wherein a first gap between pixel areas adjacent in a first direction is formed narrower than a second gap between pixels adjacent in a second direction that is perpendicular to the first direction.

2. The display of claim 1, wherein the pixel area adjacent in the first direction is formed in the form of a hexagon with narrow edges.

3. The display of any one of claims 1 to 2, wherein a first width of a barrier rib between the pixel areas adjacent in the first direction is formed narrower than a second width of a barrier rib between the pixels adjacent in the second direction.

4. The display of claim 1, comprising:
a connection portion connecting a first pixel area and a second pixel area that are adjacent in the first direction.

5. The display of claim 4, wherein a first width of the connection portion is formed narrower than a second width of the first pixel area.

6. The display of claim 4, wherein a width of the connection portion is formed substantially the same as a width of the first pixel area.

7. The display of any one of claims 5 to 6, comprising:
at least one internal barrier rib disposed in the connection portion.

8. The display of claim 7, wherein the at least one internal barrier rib is formed to protrude from the barrier rib in a direction of the connection portion.

9. The display of claim 7, wherein the at least one internal barrier rib is formed in the form of an island within the connection portion.

10. The display of any one of claims 7 to 8, wherein the at least one inner barrier rib is formed in an elongated "I" or " I " shape in the first direction within the connection portion.

11. The display of any one of claims 7 to 8, wherein a first side of the at least one inner barrier rib is disposed in at least a portion of the first pixel area, and a second side of the at least one inner barrier rib is disposed in at least a portion of the second pixel area.

12. The display of any one of claims 7 to 11, comprising:
a first conductive layer disposed on at least one of a top surface, a side surface, or a bottom surface of the barrier rib.

13. The display of any one of claims 7 to 12, comprising:
a second conductive layer disposed on at least one of a top surface, a side surface, or a bottom surface of the internal barrier rib.

14. The display of any one of claims 12 to 13, wherein the first conductive layer disposed on the top surface of the barrier rib and the second conductive layer disposed on the top surface of the inner barrier rib are electrically connected.

15. The display of any one of claims 1 to 14, comprising:
conductive layers disposed in each of the pixel areas,
wherein the conductive layers disposed in each of the pixel areas are electrically connected.
